# EUROPEAN PATENT APPLICATION

(11) **EP 4 840 865 A1**
(43) Date of publication of application: **18.11.2026**
(21) Application number: 25175871.0
(22) Date of filing: 12.05.2025
(51) Int. Cl.: C07F 5/02, C09K 11/06, H10K 85/00, H10K 30/50

(54) **NOVEL FLUORENYLIDENE SUBSTITUTED CARBORANES AND THEIR USE IN OPTOELECTRONIC AND PHOTOELECTROCHEMICAL DEVICES**

(71) Applicant: Helmholtz-Zentrum Berlin für Materialien und Energie GmbH, 14109 Berlin (DE); Kaunas University of Technology, 44249 Kaunas (LT)
(72) Inventor: ZIMMERMANN, Lea, 10965 Berlin (DE); MAHBOUBI SOUFIANI, Arman, 12055 Berlin (DE); MALINAUSKAS, Tadas, 49317 Kaunas (LT); PETRULEVICIUS, Julius, 99239 Pagegiai (LT); DASKEVICIENE, Maryte, 55232 Jonava (LT); BERNARDES DE ARAUJO, Wander Max, 10783 Berlin (DE); ALBRECHT, Steve, 14542 Werder (Havel) (DE); GETAUTIS, Vytautas, 51390 Kaunas (LT); KURPIERS, Jona, 12557 Berlin (DE); KÖHNEN, Eike, 12559 Berlin (DE); STANNOWSKI, Bernd, 12587 Berlin (DE)
(74) Representative: Schulz Junghans Patentanwälte PartGmbB

(57) **Abstract**

The present invention relates to a compound, comprising a substituted carborane, substituted with at least one functional group selected from the group consisting of substituted fluorenylidene, wherein the carborane is substituted at one or more boron atom and/or at one or more carbon atom. The invention further relates to an electron transporting material comprising a substituted carborane, substituted with at least one functional group selected from the group consisting of substituted fluorenylidene, and a solar cell comprising one or more layers of an electron transporting material comprising a substituted carborane, substituted with at least one functional group selected from the group consisting of substituted fluorenylidene, wherein the solar cell is a p-i-n solar cell.

## Description

### Background

Perovskites, in the context of photovoltaics, refer to a class of hybrid organic-inorganic metal halide compounds that adopt the ABX₃ crystal structure, where 'A' is a monovalent cation (e.g., methylammonium, formamidinium, and/or cesium), 'B' is a divalent metal cation (e.g. lead and/or tin), and 'X' is a halide anion (chloride, bromide, and/or iodide). These materials exhibit exceptional optoelectronic properties, including high absorption coefficients and high defect tolerance. A particularly advantageous feature is their tuneable bandgap, which can be adjusted through compositional engineering, making them highly suitable for multi-junction solar cells in which two or more absorbers with different band gaps are combined. Such architectures enable to achieve power conversion efficiencies (PCEs) that exceed the efficiency limit for single-junction devices. In these multi-junction configurations, perovskite absorbers can be combined either with other perovskite layers or with established technologies such as crystalline silicon. Recently perovskite/Si tandem solar cells achieved a certified efficiency of 34.85 %. In these tandem devices, a p-i-n architecture is typically employed for the perovskite top cell.

The choice of the electron transport material (ETM) plays a critical role in achieving high performance PSCs as they not only govern electron extraction and transport from the perovskite layer to the contact, but also protect the perovskite from contact with ambient environment. Buckminsterfullerene, C₆₀, is the prevalent electron-transporting material (ETM) used in high-efficiency p-i-n perovskite single-junction and multi-junction solar cells.

However, C₆₀ presents several challenges, including high non-radiative recombination losses as well as a "downwards" conduction band offset at the perovskite/C₆₀ interface that limit the device's open-circuit voltage (*V*_{OC}), high material costs, and the formation of mechanically weak interfaces prone to delamination. Additionally, its high parasitic absorption reduces the subcell current in multi-junction cells or semi-transparent single-junction solar cells.

In other works, the high parasitic absorption losses have been addressed by reducing the electron transporting layer thickness. However, adapting this approach introduces a trade-off between gain in the photo-current (*J*_{SC}) and losses in the fill factor (FF) of the device, ultimately constraining the extent to which the layer thickness can be reduced.

To address the high non-radiative recombination losses at the perovskite/C₆₀ interface, thin passivation interlayers and/or perovskite surface treatments are applied. These approaches, however, require the deposition of multiple layers, which increases the complexity of the fabrication process.

Furthermore, C₆₀-derivates such as phenyl-C₆₁-butyric acid methyl ester have been introduced to tackle the challenges of pristine C₆₀. While these derivatives offer improvements over C₆₀, they do not fully resolve its inherent limitations. Moreover, C₆₀-derivatives are typically restricted to solution-based deposition methods such as spin-coating, which limits their scalability and compatibility with industrial processes.

Due to these limitations, there is growing interest in alternative non-fullerene ETMs. These alternative ETMs range from polymers, to inorganic materials such as SnOₓ or Bi₂S₃ and small organic molecules.

Many ETMs, such as those derived from naphthalene diimide (NDI) or perylene diimide (PDI), demonstrate lower power conversion efficiencies (PCEs) than their fullerene counterparts, primarily due to higher non-radiative recombination losses and/or suboptimal energy level alignment. Despite improvements, some ETMs still suffer from low electron mobility and poor film-forming ability, leading to non-uniform layers or pinholes that compromise device performance. Additionally, several small-molecule ETMs, although easier to synthesize and often highly crystalline, face challenges such as low solubility and limited ambient stability. Furthermore, the need for precise control over molecular orientation and energy levels complicates material design. While strategies like doping, amine functionalization, and bilayer structures have shown promise in enhancing performance and stability, the scalability, synthetic complexity, and cost-effectiveness of many of these advanced ETMs remain unresolved issues. Overall, continued material innovation is necessary to overcome these drawbacks and realize efficient, stable, and commercially viable PSCs. Prior work furthermore has been focused on single-junction devices with lower-bandgap perovskites. The requirements for ETMs in multi-junction architectures, where higher-bandgap perovskites are employed, are particularly demanding, as they must not only ensure sufficient charge carrier selectivity (hole-blocking ability and low electron contact resistivity) but also feature minimal parasitic absorption to prove superior to C₆₀. Moreover, fullerene-free ETMs explored so far have been processed via spin-coating, which limits their suitability for large-area industrial fabrication and is not compatible with industry-typical textured surfaces.

In the patent application DE 10 2022 131 785 A1, carborane based ETMs substituted with simple phenyl, pyridine and piperidine residues have been disclosed. The materials have been used as intermediate-layer in between a layer of C₆₀ and perovskite. When applied as interlayer in combination with C₆₀ as ETM, increased PCEs due to improvements in the FF and reduction in non-radiative recombination losses were reported. However, there is no evidence demonstrating that the ETMs disclosed in the application function effectively as stand-alone electron transporting materials without the addition of a fullerene layer. Additionally, the carborane based ETMs therein are deposited via spin-coating, which limits the scalability of these materials and their compatibility with textured surfaces.

Based on the above-mentioned state of the art, the objective of the present invention is to provide means and methods to novel fluorenylidene substituted carboranes and the use of these carboranes as electron transporting material in perovskite solar cells. This objective is attained by the subject-matter of the independent claims of the present specification, with further advantageous embodiments described in the dependent claims, examples, figures and general description of this specification.

### Summary of the Invention

A first aspect of the invention relates to a compound, comprising a substituted carborane, substituted with at least one functional group selected from the group consisting of substituted fluorenylidene, wherein the carborane is substituted at one or more boron atom and/or at one or more carbon atom.

A second aspect of the invention relates to an electron transporting material comprising a compound according to the first aspect of the invention.

A third aspect of the invention relates to a solar cell comprising one or more layers of an electron transporting material according to the second aspect of the invention and one or more layers of perovskite, wherein the solar cell is a p-i-n solar cell.

### Terms and definitions

### General

For purposes of interpreting this specification, the following definitions will apply and whenever appropriate, terms used in the singular will also include the plural and vice versa. In the event that any definition set forth below conflicts with any document incorporated herein by reference, the definition set forth shall control.

The terms "comprising", "having", "containing", and "including", and other similar forms, and grammatical equivalents thereof, as used herein, are intended to be equivalent in meaning and to be open-ended in that an item or items following any one of these words is not meant to be an exhaustive listing of such item or items, or meant to be limited to only the listed item or items. For example, an article "comprising" components A, B, and C can consist of (i.e., contain only) components A, B, and C, or can contain not only components A, B, and C but also one or more other components. As such, it is intended and understood that "comprises" and similar forms thereof, and grammatical equivalents thereof, include disclosure of embodiments of "consisting essentially of" or "consisting of."

Where a range of values is provided, it is understood that each intervening value, to the tenth of the unit of the lower limit, unless the context clearly dictates otherwise, between the upper and lower limit of that range and any other stated or intervening value in that stated range, is encompassed within the disclosure, subject to any specifically excluded limit in the stated range. Where the stated range includes one or both of the limits, ranges excluding either or both of those included limits are also included in the disclosure.

Reference to "about" a value or parameter herein includes (and describes) variations that are directed to that value or parameter per se. For example, description referring to "about X" includes description of "X."

As used herein, including in the appended claims, the singular forms "a", "or" and "the" include plural referents unless the context clearly dictates otherwise.

"And/or" where used herein is to be taken as specific recitation of each of the two specified features or components with or without the other. Thus, the term "and/or" as used in a phrase such as "A and/or B" herein is intended to include "A and B," "A or B," "A" (alone), and "B" (alone). Likewise, the term "and/or" as used in a phrase such as "A, B, and/or C" is intended to encompass each of the following aspects: A, B, and C; A, B, or C; A or C; A or B; B or C; A and C; A and B; B and C; A (alone); B (alone); and C (alone).

Unless defined otherwise, all technical and scientific terms used herein have the same meaning as commonly understood by one of ordinary skill in the art (e.g. organic synthesis). Standard techniques are used for chemical methods.

The term *carborane* in the context of the present specification relates to compounds composed of boron (B), carbon (C), and hydrogen (H) atoms, characterized by their polyhedral, cage-like molecular structures, where the atoms form highly stable clusters. Carboranes in the context of the present specification generally comprise the general formula C₂BₙHₙ, C₂BₙHₙ₊₁, or C₂BₙHₙ₊₂, where *n* ranges from 3 to 10. In certain embodiments, a carborane is a *closo-*carborane, a *vertex*-carborane, a *nido*-carborane or an *arachno*-carborane. In certain embodiments, a carborane is a *closo*-carborane or a *vertex*-carborane. In certain embodiments, the carbon atoms are positioned at 1 and 2, or 1 and 7, or 1 and 12. Examples of carboranes include but are not limited to 1,2-C₂B₁₀H₁₂, 1,7-C₂B₁₀H₁₂, 1,12-C₂B₁₀H₁₂, 1,2-C₂B₁₀H₁₀, 1,2-C₂B₁₀H₁₁, 1,6-C₂B₈H₁₀, 1,2-C₂B₈H₁₀, 1,10-C₂B₈H₁₀, 4,5-C₂B₇H₁₃, B₁₀H₁₄, 4,6-C₂B₇H₁₃. In certain embodiments, the carborane is substituted at one or more carbon atoms, or at one or more boron atoms, or at one or more carbon atoms and one or more boron atoms. In certain embodiments, the carborane is substituted at one or more carbon atoms.

The term *substituted fluorenylidene* in the context of the present specification relates to 9-fluorenylidene, wherein 9-fluorenylidene is substituted at least at the bridging methylene group of fluorene and optionally at one or more positions of one or both phenyl moieties.

The term *electron transporting material* in the context of the present specification relates to a type of semiconductor material used in optoelectronic devices, such as solar cells, light emitting diodes (LEDs), and photodetectors to facilitate the selective extraction and transport of electrons while blocking holes, i.e. the positively charged carriers.

Any patent document cited herein shall be deemed incorporated by reference herein in its entirety.

The formulae of the present specification follow the convention of organic chemistry to not show hydrogen atoms on carbon scaffolds. Carbon is tetravalent and bonds not shown are assumed to be hydrogen unless shown otherwise.

The term *alkyl* in the context of the present specification relates to a saturated linear, branched or (partially or completely) cyclic hydrocarbon, wherein in certain embodiments one carbon-carbon bond may be unsaturated and one or more CH₂ moiety may be exchanged for oxygen (ether bridge), nitrogen (NH, or NR with R being a halogen, OH, SH, methyl, ethyl, propyl, butyl, pentyl, hexyl, OMe, OEt, OPr, OBu, O-pentyl, O-hexyl, an aryl, a heterocycle, a cycloalkyl; amino bridge), sulphur (SH or SO₂), carbonyl (C(=O)), silicon (Si-O, SiHR, SiH₂, SiR₂ with R being a halogen, OH, SH, methyl, ethyl, propyl, butyl, pentyl, hexyl, OMe, OEt, OPr, OBu, O-pentyl, O-hexyl, an aryl, a heterocycle, a cycloalkyl), PO₂, boron (BR with R being a halogen, OH, SH, methyl, ethyl, propyl, butyl, pentyl, hexyl, OMe, OEt, OPr, OBu, O-pentyl, O-hexyl, an aryl, a heterocycle, a cycloalkyl). The term *unsubstituted alkyl* when used herein in the narrowest sense relates to the moiety -CₙH₂ₙ- if used as a bridge between moieties of the molecule, or -CₙH₂ₙ₊₁ if used in the context of a terminal moiety. It may still contain fewer H atoms if used in the context of a (mono- or poly-) cyclical structure. In certain embodiments, alkyl is limited to linear alkyl.

The term *substituted alkyl* in its broadest sense refers to an alkyl as defined above in the broadest sense, which is covalently linked to an atom that is not carbon or hydrogen, particularly to an atom selected from N, O, F, B, Si, P, S, Cl, Br and I, which itself may be - if applicable - linked to one or several other atoms of this group, or to hydrogen, or to an unsaturated or saturated hydrocarbon (alkyl or aryl in their broadest sense). In a narrower sense, *substituted alkyl* refers to an alkyl as defined above in the broadest sense that is substituted in one or several carbon atoms by groups selected from amine NH₂, alkylamine NHR, imide NH, alkylimide NR, amino(carboxyalkyl) NHCOR or NRCOR, hydroxyl OH, oxyalkyl OR, oxy(carboxyalkyl) OCOR, carbonyl O and its ketal or acetal (OR)₂, nitrile CN, isonitrile NC, cyanate CNO, isocyanate NCO, thiocyanate CNS, isothiocyanate NCS, fluoride F, chloride Cl, bromide Br, iodide I, phosphonate PO₃H₂, PO₃R₂, phosphate OPO₃H₂ and OPO₃R₂, sulfhydryl SH, sulphalkyl SR, sulfoxide SOR, sulphonyl SO₂R, sulphanylamide SO₂NHR, sulphate SO₃H and sulphate ester SO₃R, with R being defined further in the description. In certain embodiments, R is itself an unsubstituted or substituted C₁ to C₁₂ alkyl in its broadest sense, and in a narrower sense, R is methyl, ethyl or propyl unless otherwise specified.

The term *C₁-C₄ alkyl* in the context of the present specification relates to a saturated linear or branched hydrocarbon having 1, 2, 3 or 4 carbon atoms. Non-limiting examples for a C₁-C₄ alkyl are methyl, ethyl, propyl, prop-2-enyl, n-butyl, 2-methylpropyl, *tert*-butyl, cyclo-butyl, cyclo-propyl, methyl-cyclo-propyl. In certain embodiments, a C₁-C₄ alkyl is a methyl, ethyl, propyl or butyl moiety.

A *C₁-C₆ alkyl* in the context of the present specification relates to a saturated linear or branched hydrocarbon having 1, 2, 3, 4, 5 or 6 carbon atoms. Non-limiting examples for a C₁-C₆ alkyl include the examples given for C₁-C₄ alkyl above, and additionally n-pentyl, n-hexyl, 2-methylbutyl, 3-methylbutyl, 1,1-dimethylpropyl, 1,2-dimethylpropyl, 1,2-dimethylpropyl.

A *C₁-C₃₀ alkyl* in the context of the present specification relates to a saturated linear or branched hydrocarbon having 1 to 30 carbon atoms. Non-limiting examples for a C₁-C₃₀ alkyl include the examples given for C₁-C₄ alkyl and C₁-C₆ alkyl above, and additionally n-heptyl, n-octyl, n-nonyl, n-decyl, n-dodecyl, n-tetradecyl, n-hexadecyl, n-octadecyl, n-nonadecanyl, n-eicosanyl, n-docosanyl, n-tetracosanyl, n-pentacosanyl, n-octacosanyl, n-triacontanyl and branched derivatives thereof.

In the context of the present specification, the term alkyl also encompasses unsaturated hydrocarbons such as alkene and alkyne.

Where used in the context of chemical formulae, the following abbreviations may be used: *Me* is methyl CH₃, *Et* is ethyl -CH₂CH₃, *Prop* is propyl -(CH₂)₂CH₃ (n-propyl, n-pr) or -CH(CH₃)₂ (iso-propyl, i-pr), *but* is butyl -C₄H₉, -(CH₂)₃CH₃, -CHCH₃CH₂CH₃, -CH₂CH(CH₃)₂ or -C(CH₃)₃.

The term *alkene* in the context of the present specification relates to a hydrocarbon comprising a double bond. Unsubstituted alkene (alkenyl) is of formula -CH=CH- when being located intramolecularly, and of formula -CH-CH₂ when being a terminal moiety. An unsubstituted alkene (alkenyl) consists of C and H only. A substituted alkene (alkenyl) may comprise substituents as defined herein for substituted alkyl. In certain embodiments, an alkene as contemplated herein is a linear alkene. In certain embodiments, an alkene as contemplated herein is a cyclic alkene. Cyclooctatetraene is contemplated in certain embodiments as a variant of alkene.

The term *aryl* in the context of the present specification relates to a cyclic aromatic C₅-C₁₀ hydrocarbon. Examples of aryl include, without being restricted to, phenyl and naphthyl.

In the context of the present specification, the term aryl encompasses hydrocarbon-based aryl and heteroaryl.

The term *heteroaryl* in the context of the present specification relates to a cyclic aromatic C₂-C₉ hydrocarbon that comprises at least one heteroatom (e.g. N, O, S). Examples for heteroaryl include, without being restricted to, pyrrole, thiophene, furan, imidazole, pyrazole, thiazole, oxazole, pyridine, pyrimidine, thiazine, quinoline, benzofuran and indole.

The term *cycloalkyl* in the context of the present specification relates to a saturated hydrocarbon ring having 4, 5, 6 or 7 carbon atoms, wherein in certain embodiments, one carbon-carbon bond may be unsaturated and/or one CH₂ moiety may be exchanged for oxygen (ether bridge) or nitrogen (NH, or NR with R being methyl, ethyl, or propyl; amino bridge). Non-limiting examples of a cycloalkyl moiety include cyclobutyl (-C₄H₇), cyclopentenyl (C₅H₉), and cyclohexenyl (C₆H₁₁) moieties.

The term *heterocycle* in the context of the present specification relates to a saturated hydrocarbon ring having 3, 4, 5, 6 or 7 carbon atoms, wherein one carbon-carbon bond may be unsaturated and/or one or more CH₂ moiety may be exchanged for oxygen (ether bridge)m, sulphur or nitrogen (NH, or NR with R being methyl, ethyl, or propyl; amino bridge). Non-limiting examples of a heterocycle moiety include ethylenoxide, ethylenimine, propylenimine, trimethyloxide, pyrrolidine, tetrahydrofuran, tetrahydrothiophene, piperidine, tetrahydropyran, tetrahydrothiopyran, hexamethylenamine, hexamethylenoxide, hexamethylensulfide.

The term *halogen* refers to a member of the group fluorine, chlorine, bromine and iodine. In particular embodiments, the term refers to a member of the group chlorine, bromine and iodine. In other particular embodiments, the term refers to a member of the group chlorine and bromine.

### Detailed Description of the Invention

A first aspect of the invention relates to a compound, comprising a substituted carborane, substituted with at least one functional group selected from the group consisting of substituted fluorenylidene, wherein the carborane is substituted at one or more boron atom and/or at one or more carbon atom.

The carborane itself does not lead to extraction of electrons from perovskite in solar cells. However, the carborane is important for properties such as charge carrier mobility, positioning of the functional groups in relation to each other, position of the energy levels and film formation on the perovskite absorber. Additionally, the 9-fluorenylidene functional group was found to be responsible for charge extraction of these molecules since the isolated functional group, as a stand-alone ETM showed signs of charge extraction in perovskite single-junction devices. Increase in *V*_{OC}, *J*_{SC} and FF was observed in the latter case resulting in higher PCE compared to devices without ETM between the perovskite absorber and the SnOₓ buffer layer. Thus, fluorenylidene substituted carboranes function as stand-alone ETM without an additional C₆₀ layer, while exceeding PCE values of solar cells employing prevalently used C₆₀ The data shown herein are exceeding PCE values compared to shown data of stand-alone non-fullerenes and non-fullerene intermediate layers shown in the prior art. Notably, the replacement of C₆₀ with fluorenylidene substituted carboranes reduces non-radiative recombination compared to C₆₀, thus, increasing the *V*_{OC} perovskite solar cells.

Since no additional passivation or interlayer is needed to achieve high *V*_{OC} values, the use of a fluorenylidene substituted carborane ETM can decrease the complexity of the fabrication step.

Due their excellent compatibility with thermal evaporation processes fluorenylidene substituted carborane ETMs further enable the scalable fabrication of perovskite solar cells and the compatibility with textured surfaces. This makes these ETMs highly suitable for the application in large-area perovskite-based solar cells and tandem solar cells on industry-relevant textured silicon bottom cells.

In certain embodiments, the carborane is selected from the group consisting of ortho-carborane, meta-carborane or para-carborane.

In certain embodiments, the carborane is selected from the group consisting of ortho-carborane, and meta-carborane.

In certain embodiments, the carborane is selected from the groups consisting of *closo-*carborane, *vertex*-carborane, *nido*-carborane and *arachno*-carborane.

In certain embodiments, the carborane is a *closo*-carborane or a *vertex*-carborane.

In certain embodiments, the carborane is a *closo*-carborane.

In certain embodiments, the carborane is a *closo*-dicarbadecaborane or a vertex-dicarbaoctocarborane.

In certain embodiments, the carborane is selected from the group consisting of 1,2-*closo-*dicarbadecaborane, 1,7-*closo*-dicarbadecaborane, 1,12-*closo*-dicarbadecaborane, 1,6-*vertex*-dicarbaoctocaborane, 1,2-*vertex*-dicarbaoctocaborane, and 1,10-*vertex-*dicarbaoctocaborane.

In certain embodiments, the carborane is selected from the group consisting of 1,2-*closo-*dicarbadecaborane, 1,7-*closo*-dicarbadecaborane, 1,6-*vertex*-dicarbaoctocaborane, 1,2-*vertex*-dicarbaoctocaborane.

In certain embodiments, the carborane is substituted at one or more boron atom.

In certain embodiments, the carborane is substituted at one or more carbon and one or more boron atom.

In certain embodiments, the carborane is substituted at one or more carbon atom.

In certain embodiments, the carborane is one of formula (X-1); , (X-2), and (X-3), 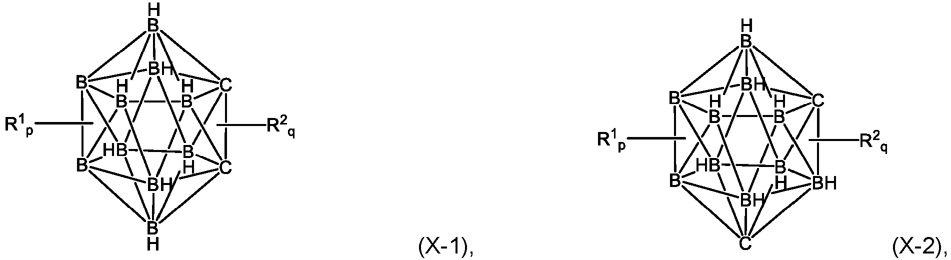 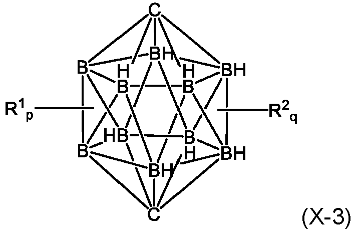 wherein R¹ and R² are each selected from the group consisting of substituted fluorenylidene, and p is an integer in the range of 1 to 6, q is an integer in the range of 0 to 6, wherein the sum of p and q is an integer in the range of 1 to 12, and wherein each R¹ and R² are positioned at one or more carbon atom and/or one or more boron atom.

In certain embodiments, the sum of p and q is an integer in the range of 1 to 10.

In certain embodiments, the sum of p and q is an integer in the range of 1 to 4.

In certain embodiments, the sum of p and q is 1 or 2.

In certain embodiments, the compound is selected from any one of the formulae (I) to (VI) 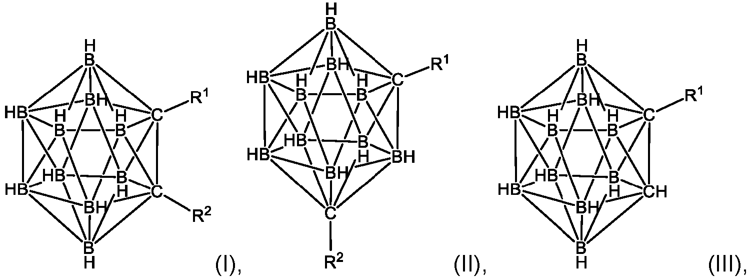 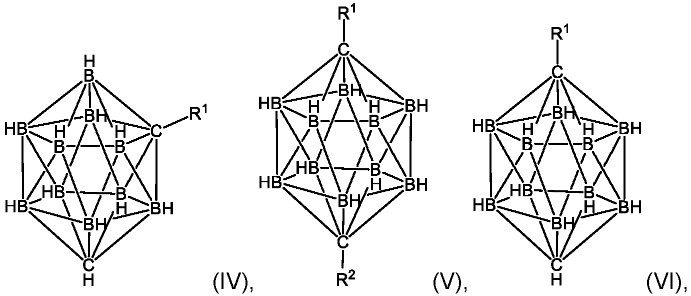 wherein R¹ and R² are each selected from the group consisting of substituted fluorenylidene.

In certain embodiments, the compound is selected from any one of the formulae (I) to (VI) 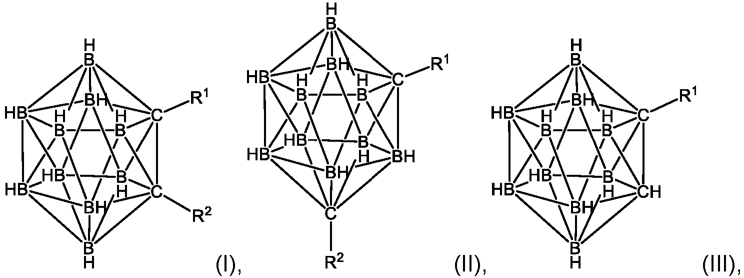 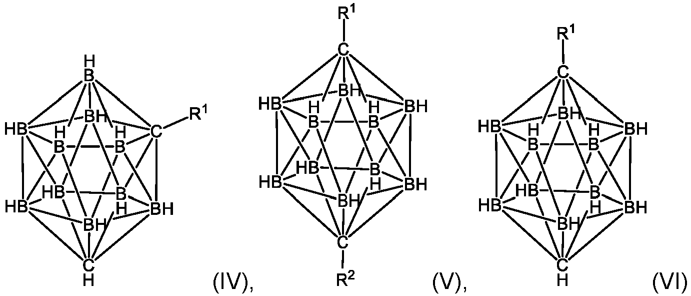 wherein R¹ and R² are each selected from the group consisting of substituted fluorenylidene.

In certain embodiments, the compound is selected from any one of the formulae (I) or (II) or (III) 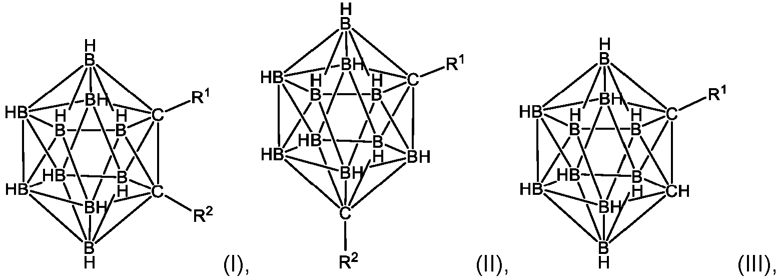 wherein R¹ and R² are each selected from the group consisting of substituted fluorenylidene.

In certain embodiments, R¹ and R² are different from one another.

In certain embodiments, R¹ and R² are identical.

In certain embodiments, R¹ and R² are each selected from a substituted fluorenylidene of formula (VII) 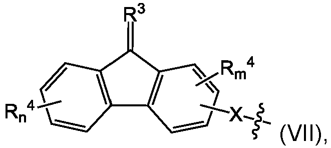 wherein
each R⁴ is selected from any of the groups consisting of
   - -F, -Cl, -Br, -I;
   - -NO₂, -OH, -NH₂;
   - -O-C₁-C₆ alkyl, -C₁-C₆ alkyl, -C₂-C₆ alkenyl;
   - an aryl;
   - a heterocycle;
      wherein n is an integer of 0, 1, 2, 3 or 4 and m is an integer of 0, 1, 2 or 3;
X is a linking fragment connecting the substituted fluorenylidene with the carborane selected from any of the groups consisting of
   - -C₁-C₃₀ alkyl-, -Y-C₁-C₃₀ alkyl-, -C₁-C₃₀ alkyl-Y-C₁-C₃₀ alkyl-, -C₁-C₃₀ alkyl-Y-, wherein Y is selected from the group consisting of -O-, -S-, -C(=O)-, -C(=O)O-, - SiO-, -SO₂-, -PO₂-, -aryl-, -heterocycle-, -cycloalkyl-, -SiR⁵R⁶-, -BR⁵-, -NR⁵-, wherein R⁵ and R⁶ are each selected from the group consisting of -H, -F, -Cl-, -Br, -I, -OH, -SH, -OC₁-C₆ alkyl, -C₁-C₆ alkyl, -C₂-C₆ alkenyl, aryl, heterocycle, cycloalkyl;
   - -C(=O)-O, -C(=O)S-, -C(=O)OSi(CH₃)₂-, -C(=O)NH-;
   - -C(=O)NH-phenyl-, -C(=O)O-phenyl-, 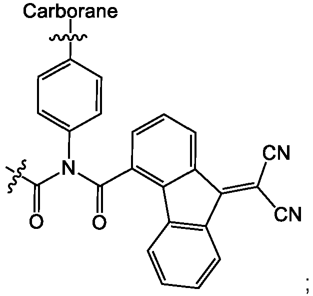
R³ is selected from the group consisting of 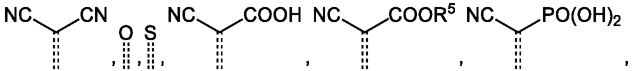 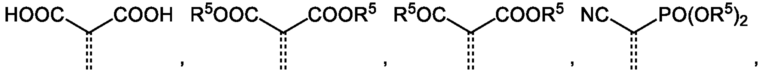 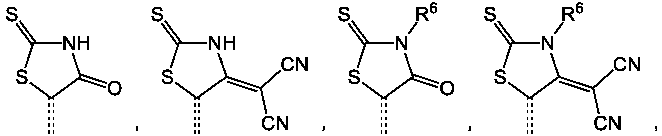 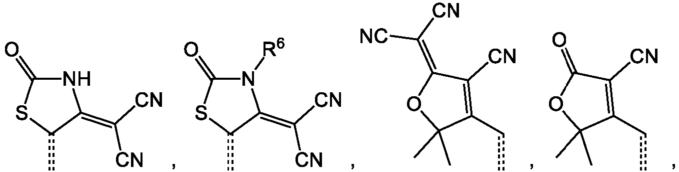 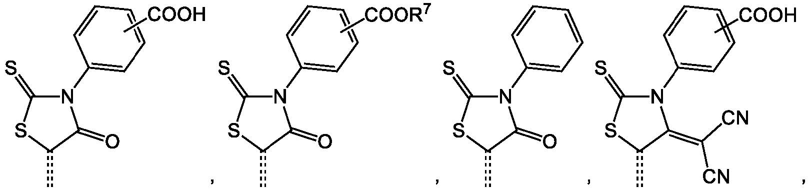 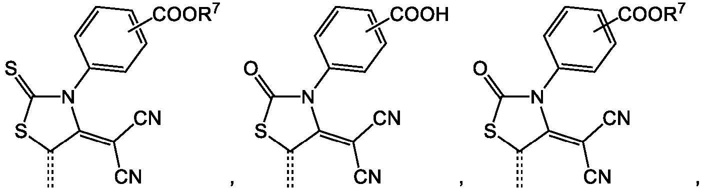 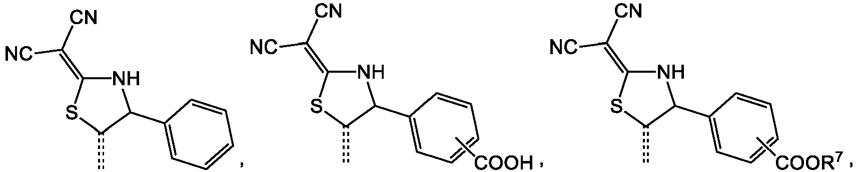 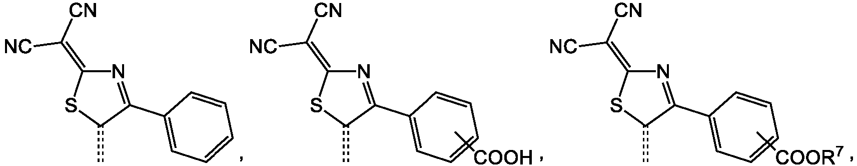 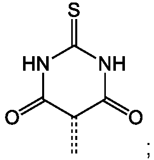
wherein
R⁵ is selected from the group consisting of unsubstituted -C₁-₄ alkyl,
R⁶ is selected from the groups consisting of unsubstituted -C₁-₄ alkyl, -C₁-₄ alkyl-COOH, and - C₁-₄ alkyl-COOR⁸, wherein R⁸ is selected from the group consisting of unsubstituted -C₁-₄ alkyl,
R⁷ is selected from the group consisting of unsubstituted -C₁-₄ alkyl,
and wherein the dashed bond represents the double bond connecting R³ and fluorenylidene in formula (VII).
9-fluorenylidene functional groups were found to be responsible for charge extraction in perovskite solar cells.

In certain embodiments, R⁴ₙ is selected from any of the groups consisting of
- -F, -Cl, -Br, -I;
- -NO₂, -OH, -NH₂;
- -O-C₁-C₆ alkyl, -C₁-C₆ alkyl, -C₂-C₆ alkenyl;
wherein n is an integer of 0, 1, 2, 3 or 4 and m is an integer of 0, 1, 2 or 3.

In certain embodiments, R⁴ₙ is selected from any of the groups consisting of
- -F, -Cl, -Br, -I;
- -NO₂, -OH, -NH₂;
wherein n is an integer of 0, 1, 2, 3 or 4 and m is an integer of 0, 1, 2 or 3.

In certain embodiments, R⁴ₙ is selected from the group consisting of
- -NO₂, -OH, -NH₂;
wherein n is 0 or 1 and m is 0 or 1.

In certain embodiments, X is a linking fragment selected from any of the groups consisting of
- -Y-C₁-C₃₀alkyl-, wherein Y is -C(=O)O-;
- C(=O)-O-, -C(=O)S-, -C(=O)OSi(CH₃)₂-;
- C(=O)NH-phenyl-, -C(=O)O-phenyl-;
-

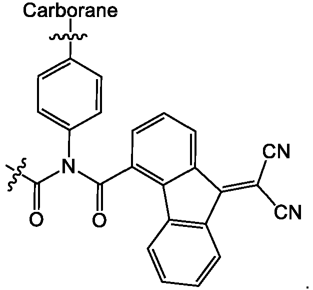

In certain embodiments, X is a linking fragment selected from any of the groups consisting of
- -Y-C₁-C₃- alkyl-, wherein Y is -C(=O)O-;
- -C(=O)-O-, -C(=O)S-, -C(=O)OSi(CH₃)₂-;
- -C(=O)NH-phenyl-, -C(=O)O-phenyl-;
-

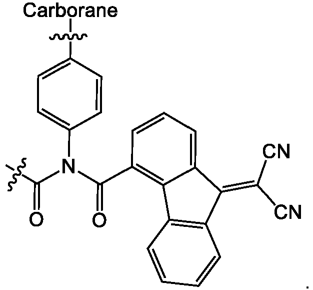

In certain embodiments, X is a linking fragment selected from any of the groups consisting of
- -Y-C₁-C₃- alkyl-, wherein Y is -C(=O)O-;
- -C(=O)-O-, -C(=O)S-, -C(=O)OSi(CH₃)₂-.

In certain embodiments, wherein X is a linking fragment selected from any of the groups consisting of
- -Y-C₁-C₃- alkyl-, wherein Y is -C(=O)O-;
- -C(=O)-O-.

In certain embodiments, R³ is selected from the group consisting of 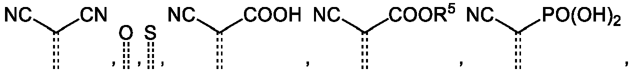 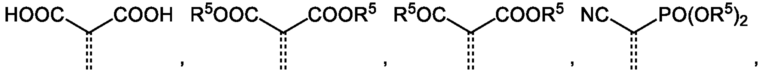 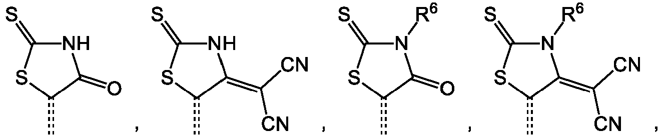 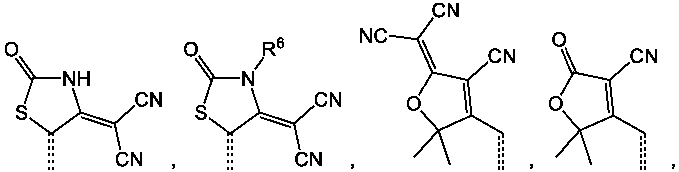 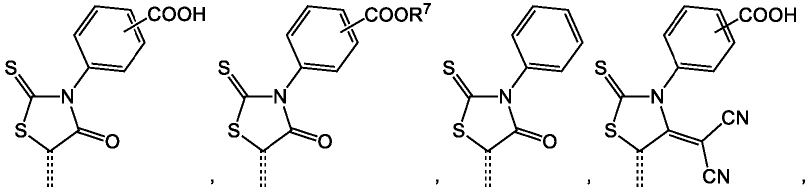 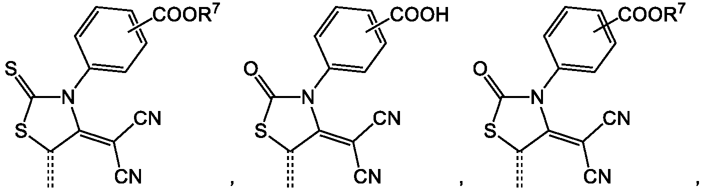 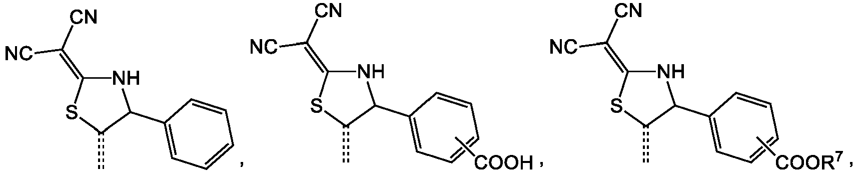 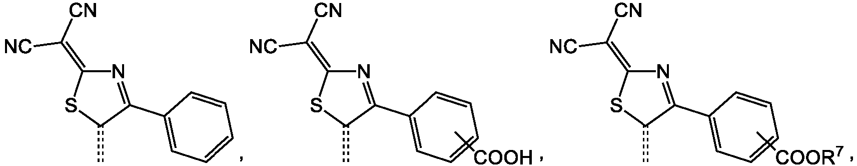 wherein
R⁵ is selected from the group consisting of unsubstituted -C₁-₄ alkyl,
R⁶ is selected from the groups consisting of unsubstituted -C₁-₄ alkyl, -C₁-₄ alkyl-COOH, and - C₁-₄ alkyl-COOR⁸, wherein R⁸ is selected from the group consisting of unsubstituted -C₁-₄ alkyl,
R⁷ is selected from the group consisting of unsubstituted -C₁-₄ alkyl,
and wherein the dashed bond represents the double bond connecting R³ and fluorenylidene in formula (VII).

In certain embodiments, R³ is selected from the group consisting of 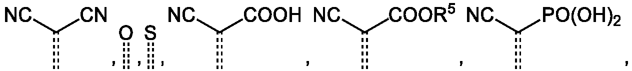 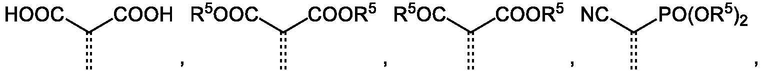 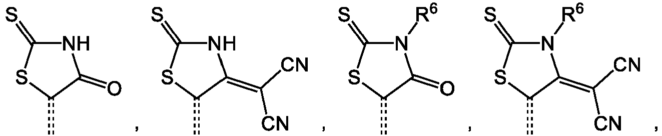 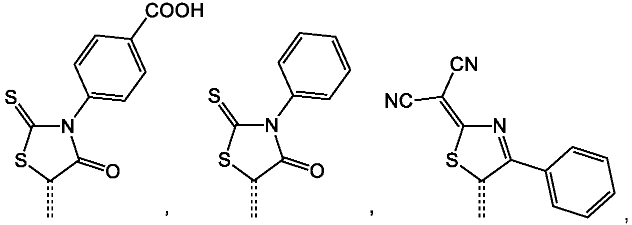 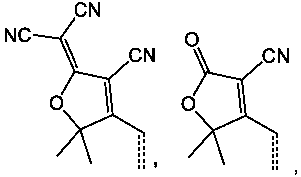 wherein
R⁵ is selected from the group consisting of unsubstituted -C₁-₄ alkyl,
R⁶ is selected from the groups consisting of unsubstituted -C₁-₄ alkyl, -C₁-₄ alkyl-COOH, and - C₁-₄ alkyl-COOR⁸, wherein R⁸ is selected from the group consisting of unsubstituted -C₁-₄ alkyl,
and wherein the dashed bond represents the double bond connecting R³ and fluorenylidene in formula (VII).

In certain embodiments, R³ is selected from the group consisting of 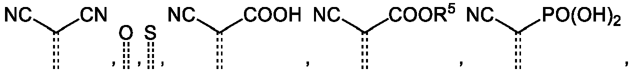 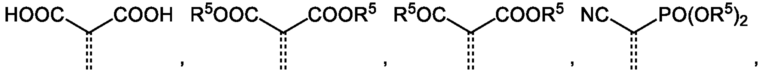 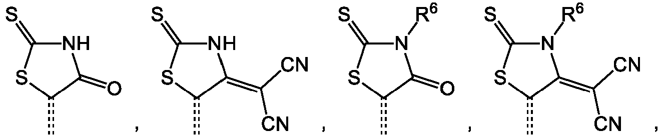 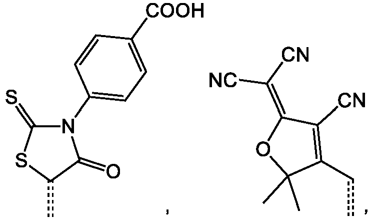 wherein
R⁶ is selected from the group consisting of unsubstituted -C₁-₄ alkyl,
R⁶ is selected from the groups consisting of unsubstituted -C₁-₄ alkyl, -C₁-₄ alkyl-COOH, and - C₁-₄ alkyl-COOR⁸, wherein R⁸ is selected from the group consisting of unsubstituted -C₁-₄ alkyl,
and wherein the dashed bond represents the double bond connecting R³ and fluorenylidene in formula (VII).

In certain embodiments, R⁶ is selected from the groups consisting of unsubstituted -C₁-₄ alkyl, and -C₁-₄ alkyl-COOH.

In certain embodiments, R³ is selected from the group consisting of 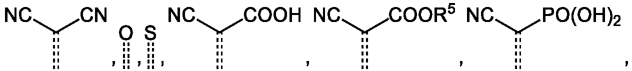 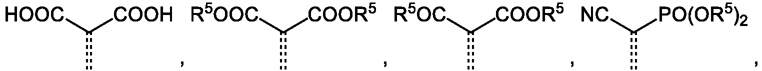 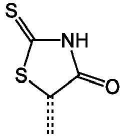 wherein
R⁵ is selected from the group consisting of unsubstituted -C₁-₄ alkyl,
and wherein the dashed bond represents the double bond connecting R³ and fluorenylidene in formula (VII).

In certain embodiments, R³ is selected from the group consisting of 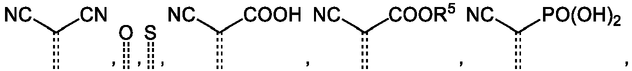 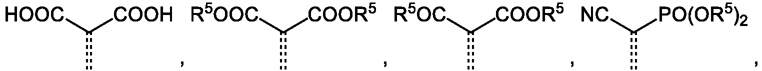 wherein
R⁵ is selected from the group consisting of unsubstituted -C₁-₄ alkyl,
and wherein the dashed bond represents the double bond connecting R³ and fluorenylidene in formula (VII).

In certain embodiments, R³ is selected from the group consisting of 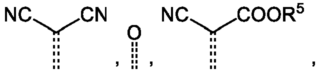 wherein
R⁵ is selected from the group consisting of unsubstituted -C₁-₄ alkyl,
and wherein the dashed bond represents the double bond connecting R³ and fluorenylidene in formula (VII).

In certain embodiments, R¹ and R² are each selected from a substituted fluorenylidene of formula (Vlla) or (Vllb) 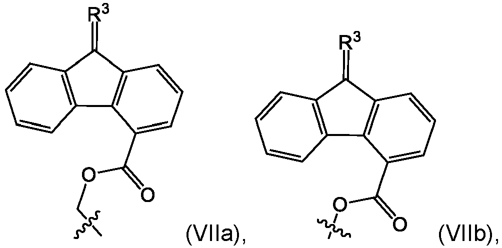 wherein
R³ is selected from the group consisting of 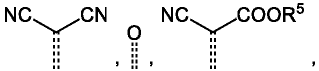
wherein
R⁵ is selected from the group consisting of unsubstituted -C₁-₄ alkyl,
and wherein the dashed bond represents the double bond connecting R³ and fluorenylidene in formula (VII).

In certain embodiments, R¹ and R² are each a substituted fluorenylidene of formula (Vlla) or (Vllb) or (Vllc)

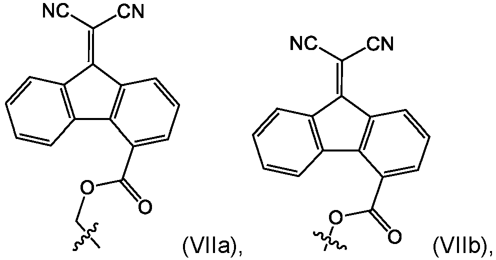

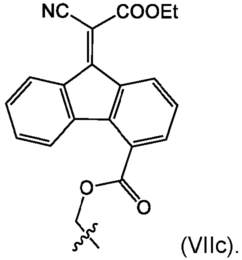

In certain embodiments, the compound is selected from any of the formulae (ETM-1), (ETM-2), (ETM-3), (ETM-4), (ETM-7) and (ETM-8)

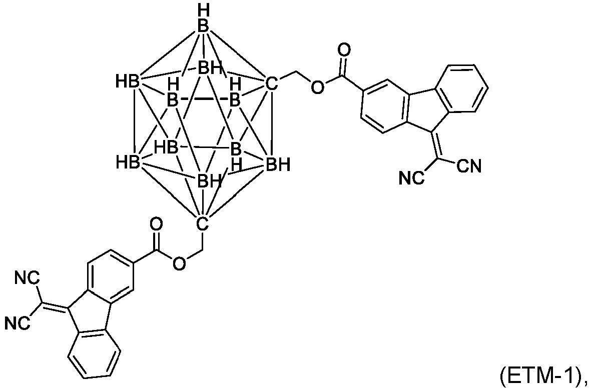

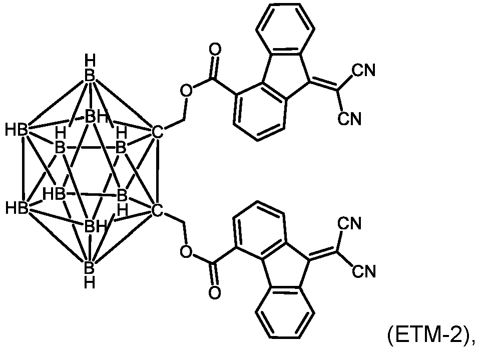

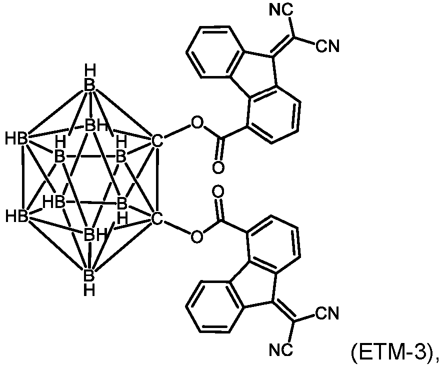

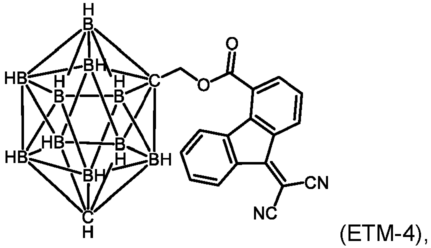

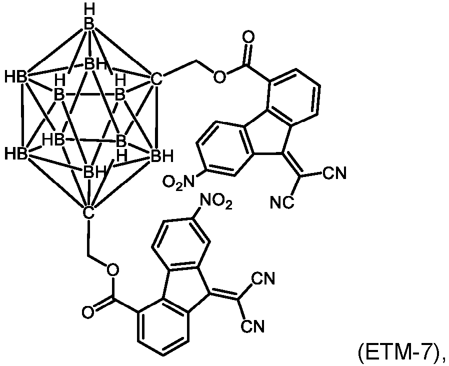

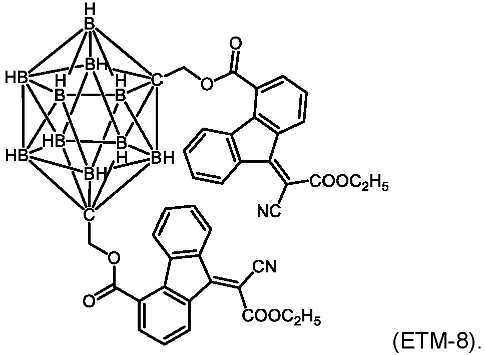

In certain embodiments, the compound is selected from any one of formula (ETM-1) and (ETM-2)

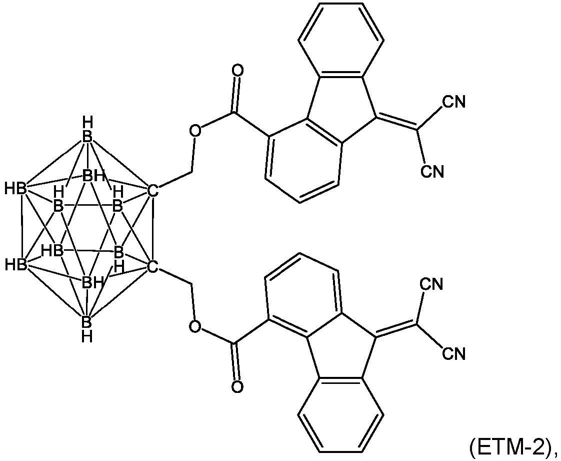

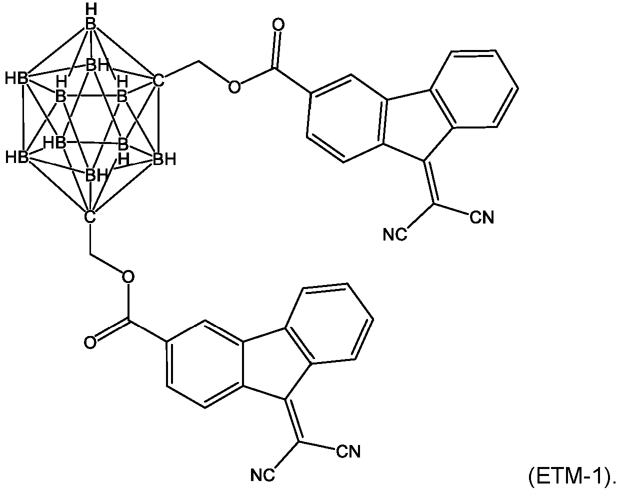

The meta- and ortho-carborane substituted with 9-fluorenylidene malononitrile functional groups could further increase the performance and show a significant increase in *V*_{OC} compared to fullerene ETMs, indicating reduced non-radiative recombination losses and a higher quality interface between the perovskite absorber and the new ETM.

In certain embodiments, the compound is selected from any one of formula (ETM-1)

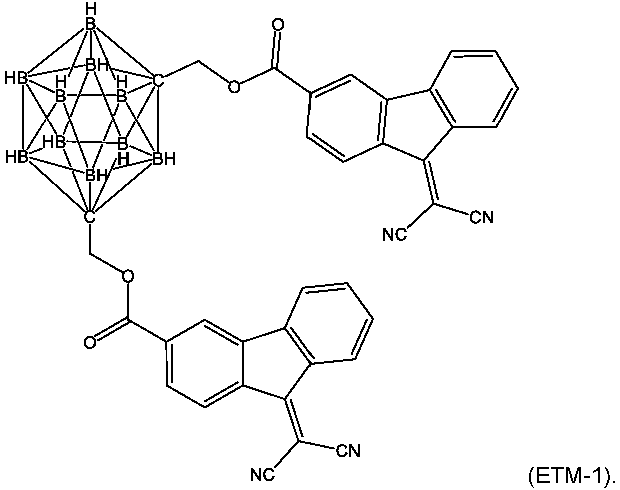

The PCE of ETM-1 when used as stand-alone ETM is higher compared to known fullerene and non-fullerene ETMs.

A second aspect of the invention relates to an ETM comprising a compound according to the first aspect of the invention.

A third aspect of the invention relates to a solar cell comprising one or more layers of an ETM according to the second aspect of the invention and one or more layers of perovskite, wherein the solar cell is a p-i-n solar cell.

In certain embodiments, the solar cell further comprises one or more layers of a hole transporting material, a transparent conducting oxide substrate and an electrode.

In certain embodiments, the transparent conductive oxide substrate is an indium tin oxide on glass.

In certain embodiments, the hole transporting material is a carbazole-based self-assembled monolayer.

Wherever alternatives for single separable features are laid out herein as "embodiments", it is to be understood that such alternatives may be combined freely to form discrete embodiments of the invention disclosed herein. Thus, any of the alternative embodiments of the first aspect of the invention may be combined with the second aspect of the invention and the third aspect of the invention.

The invention is further illustrated by the following examples and figures, from which further embodiments and advantages can be drawn. These examples are meant to illustrate the invention but not to limit its scope.

### Description of the Figures

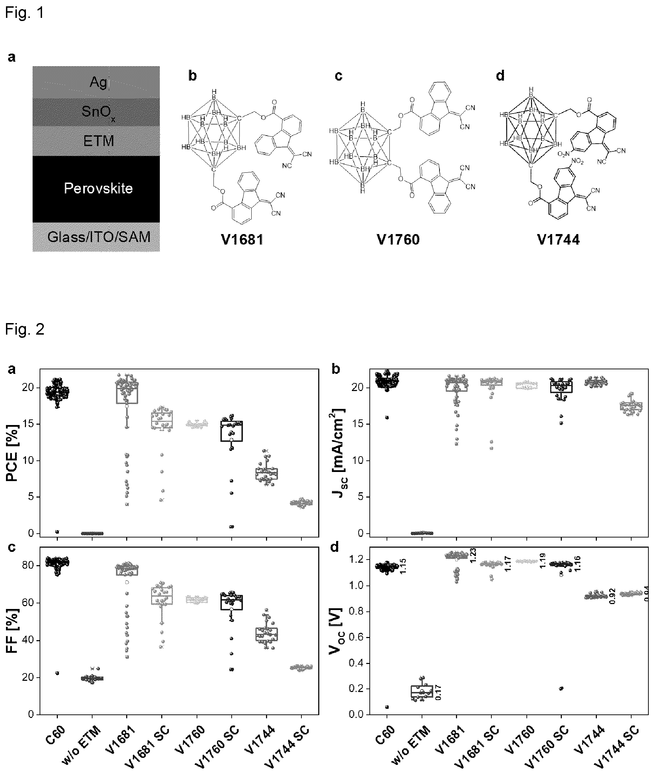

- Fig. 1: shows a) P-i-n perovskite solar cell stack consisting of glass/indium tin oxide (ITO)/self-assembled monolayer (SAM) hole transport layer (HTL)/perovskite/electron transport material (ETM)/SnOₓ/Ag. Molecule structure of b) V1681 (ETM-1), c) V1760 (ETM-2) and d) V1744 (ETM-7).
- Fig. 2: shows Box plot of the a) power conversion efficiency (PCE) in %, b) short-circuit current density (*J*_{SC}) in mA/cm², c) fill factor (FF) in % and d) open-circuit voltage (*V_{OC}*) in V of opaque single-junction solar cells with C₆₀ ETM, without (w/o ETM), and with thermally evaporated and spin-coated (SC) V1681 (ETM-1), V1760 (ETM-2) and V1744 (ETM-7) as ETM, respectively. The boxes in these diagrams range from the first to the third quartile of the data set. The horizontal line within the boxes represents the median value. The whiskers show the minimum and maximum values within a distance of 1.5 times the interquartile range (IQR, distance between first and third quartile value) to the box. The void circle indicates the mean value.

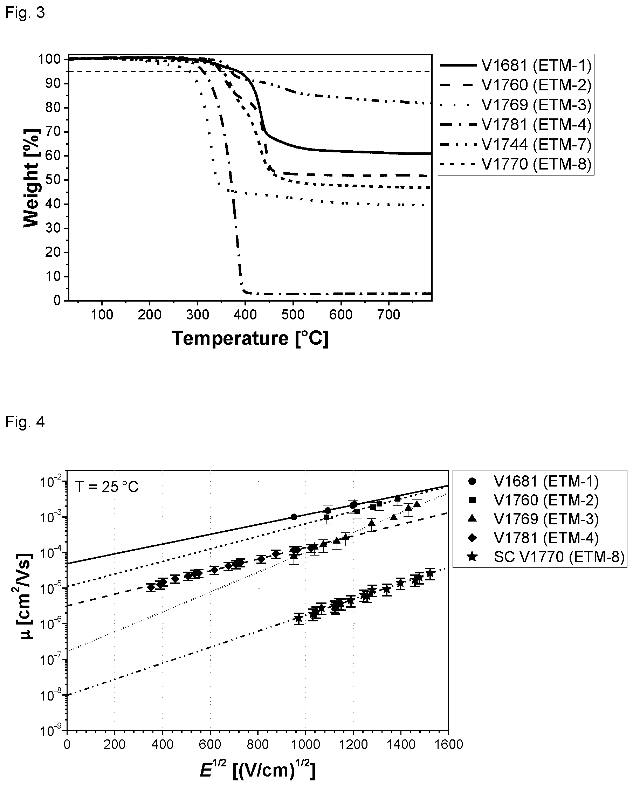

- Fig. 3: shows Thermogravimetric analysis (TGA) data, i.e. weight in % over temperature in °C of the synthesized electron transport materials (ETMs) V1681 (ETM-1), V1760 (ETM-2), V1769 (ETM-3), V1781 (ETM-4), V1744 (ETM-7), and V1770 (ETM-8). The analysis was carried out with a heating rate of 10 °C min⁻¹, and in N₂ atmosphere.
- Fig. 4: shows Field-dependent electron mobility (*µ*) in cm²/Vs plotted as a function of the square root of the applied electric field (E^{1/2}) in (V/cm)^{1/2} for carborane-based electron transport materials V1681 (ETM-1), V1760 (ETM-2), V1769 (ETM-3), V1781 (ETM-4) and V1770 (ETM-8), measured at 25 °C using xerographic time-of-flight (XTOF) measurements. V1681, V1760, V1769 and V1781 were deposited via thermal evaporation whereas the ETM V1770 was deposited via spin-coating (SC).

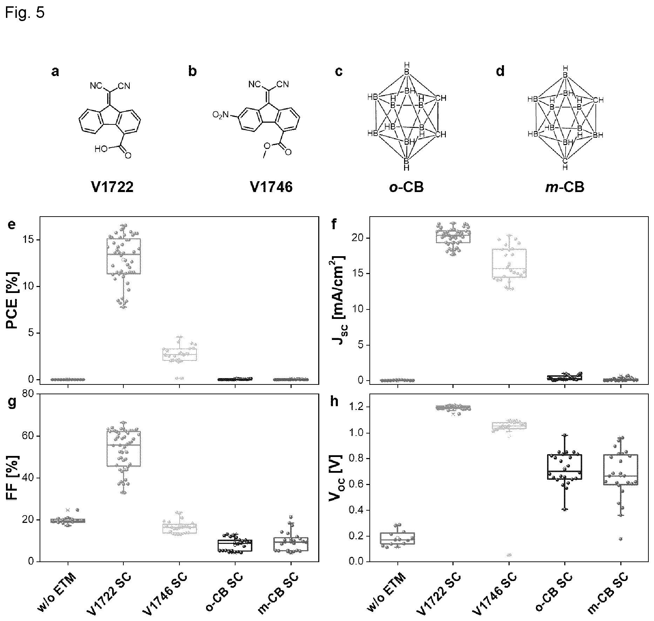

- Fig. 5: shows a) Molecule structure of V1722, b) V1746, c) *ortho*-carborane (o-CB) and d) *meta*-carborane (*m*-CB). Box plot of the e) power conversion efficiency (PCE) in %, f) short-circuit current (*J*_{SC}) density in mA/cm², g) fill factor (FF) in % and h) open-circuit voltage (*V_{OC}*) in V of opaque single-junction solar cells without (w/o ETM), and with spin-coated (SC) V1722, V1746, *o*-CB and *m*-CB as ETM. The boxes in these diagrams range from the first to the third quartile of the data set. The horizontal line within the boxes represents the median value. The whiskers show the minimum and maximum values within a distance of 1.5 times the interquartile range (IQR, distance between first and third quartile value) to the box. The void circle indicates the mean value.

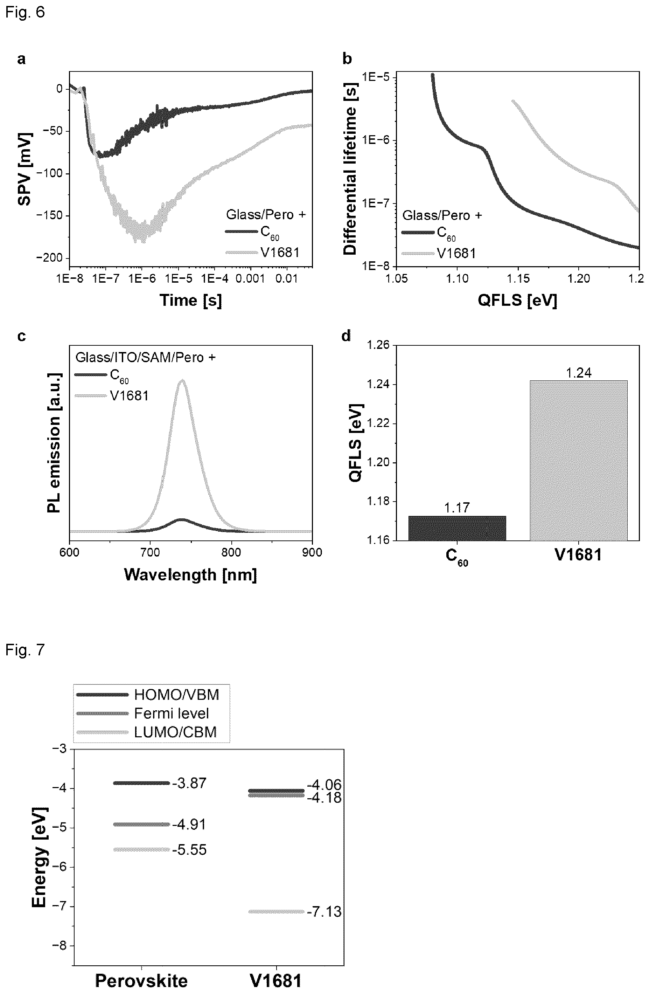

- Fig. 6: shows Energy levels of the 1.68 eV triple-cation triple-halide (3Hal) perovskite and V1681 electron transport material (ETM), referenced to the vacuum level at 0 eV. The Fermi level and valence band maximum (VBM) or highest occupied molecular orbital (HOMO) were determined by using He-I ultraviolet photoemission spectroscopy (He-UPS). The conduction band minimum (CBM) or lowest unoccupied molecular orbital (LUMO) were estimated by adding the respective band gap energies - 1.68 eV for the perovskite and 3.1 eV (determined by UV-Vis-NIR spectroscopy) for V1681 - to the VBM and HOMO levels.
- Fig. 7: shows Scanning electron microscopy (SEM) images of a) glass/indium tin oxide (ITO)/self-assembled monolayer (SAM)/triple-cation triple-halide (3Hal) perovskite and b) the layer stack topped with 16 nm C₆₀ and c) 4 nm V1681 (ETM-1). The scale bar corresponds to 200 nm.

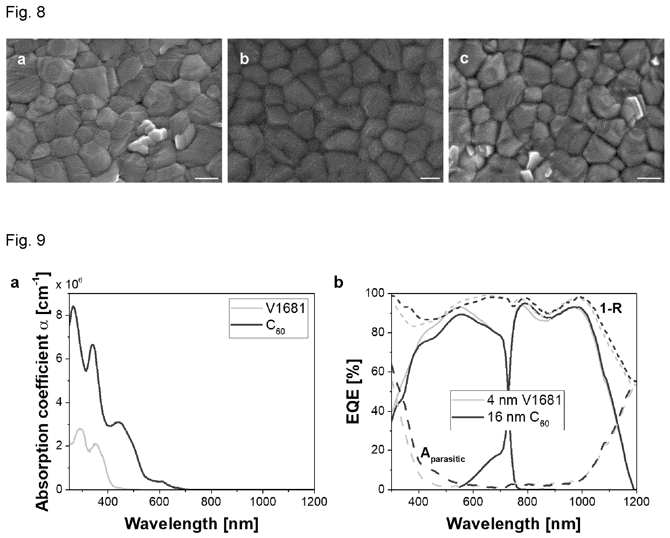

- Fig. 8: shows a) Absorption coefficient *α* in cm⁻¹ over wavelength in nm determined from ultraviolet-visible-near-infrared (UV-Vis-NIR) spectroscopy measurements of V1681 (ETM-1) and C₆₀ thin-films on quartz glass and b) external quantum efficiency (EQE) in % over illumination wavelength in nm of perovskite/silicon tandem solar cells employing a 4 nm V1681 or 16 nm C₆₀ ETM. The corresponding reflectance (1-R) and parasitic absorption (A_{parasitic}) are represented in the same plot. The integrated top cell and bottom cell current densities from the tandem device with V1681 are 19.14 and 19.86 mA/cm² and 18.48 and 20.15 mA/cm² for the device with C₆₀ ETM, respectively.

### Examples

### Example 1: Synthesis and characterisation of Carborane based compounds

The synthesis of the ETMs of this invention can be prepared by the following multi-step synthetic procedures, although other suitable procedures can be used by a person of ordinary skill in the art based on the disclosure herein.

The following steps are suitable for synthesizing some ETMs of this invention involving a linking reaction as described in the following. In the first step, diphenic acid or its derivative is dissolved in large access of concentrated sulfuric acid and the solution is heated at approximately 70 °C for about 10 minutes. The obtained 9-fluorenone-4-carboxylic acid or its derivative, is isolated. In the second step, 9-fluorenone-4-carboxylic acid or its derivative is chlorinated with thionyl chloride to form 9-fluorenone-4-carbonyl chloride or its derivative. Then 9-fluorenone-4-carbonyl chloride or its derivative reacts with o-carborane derivatives possessing hydroxyl or thiol, or amine group in the presence of triethylamine (TEA) to form the electron transport material, which can be purified and dried. Non-limiting examples of suitable *o*-carborane derivatives are *m*-carborane derivatives possessing hydroxyl or thiol, or amine groups, *p*-carborane derivatives possessing hydroxyl or thiol, or amine groups.

For other ETMs of this invention, 9-fluorenone-4-carboxylic acid or its derivative react with malononitrile in the presence of piperidine to form 9-fluorenylidenemalononitrile-4-carboxylic acid or its derivative, which can be purified and dried. Then, 9-fluorenylidenemalononitrile-4-carboxylic acid or its derivative is chlorinated with thionyl chloride to form 9-fluorenylidenemalononitrile-4-carbonyl chloride or its derivative. Finally, 9-fluorenylidenemalononitrile-4-carbonyl chloride or its derivative reacts with a *o*-carborane derivatives possessing hydroxyl or thiol, or amine groups in the presence of triethylamine to form the electron transport material, which can be purified and dried. Non-limiting examples of suitable *o*-carborane derivatives are *m*-carborane derivatives possessing hydroxyl or thiol, or amine groups, *p*-carborane derivatives possessing hydroxyl or thiol, or amine groups.

Similarly, other ETMs with different electron withdrawing groups instead of malononitrile can be formed in this invention. For example, 9-fluorenone-4-carboxylic acid or its derivative is chlorinated with thionyl chloride to form 9-fluorenone-4-carbonyl chloride or its derivative. Then 9-fluorenone-4-carbonyl chloride or its derivative reacts with an *o*-carborane derivatives possessing hydroxyl or thiol, or amine group in the presence of triethylamine to form the intermediate, which can be purified and dried. Non-limiting examples of suitable *o*-carborane derivatives are *m*-carborane derivatives possessing hydroxyl or thiol, or amine groups, *p-*carborane derivatives possessing hydroxyl or thiol, or amine groups. Finally, the intermediate product reacts with ethyl 2-cyanoacetate in the presence of piperidine in glacial acetic acid to form the ETM, which can be purified and dried. Non-limiting examples of suitable any compound having an active methylene group are (cyanomethyl)phosphonic acid, diethyl (cyanomethyl)phosphonate, cyanoacetic acid, diethylmalonate, malonic acid, rhodanine, 3-ethylrhodanine, 4-(4-oxo-2-thioxo-1,3-thiazolidin-3-yl)benzoic acid, 2-(3-ethyl-2-thioxo-4-thiazolidinylidene)propanedinitrile, 2-(4-phenyl-2(*5H*)-thiazolylidene)propanedinitrile, 2-(2-thioxo-4-thiazolidinylidene)propanedinitrile, 2-(3-ethyl-2-thioxo-4-thiazolidinylidene)propane-dinitrile, thiobarbituric acid, ethyl acetoacetate, 2-dicyanomethylene-3-cyano-4,5,5-trimethyl-2,5-dihydrofuran, 2,5-dihydro-4,5,5-trimethyl-2-oxo-3-furancarbonitrile, which can be used in the Knoevenagel condensation reaction. The Knoevenagel condensation and related reaction is described in ref.^{[1]}

### Synthesis and Characterization Electron Transport Materials

This example described the synthesis and chemical characterization of Compounds (ETM-1) -(ETM-8) in which the numbers refer to formula numbers above. Synthesis rout to the electron transporting materials ETM-1 - ETM-8 shown in Scheme 1 and Scheme 2.

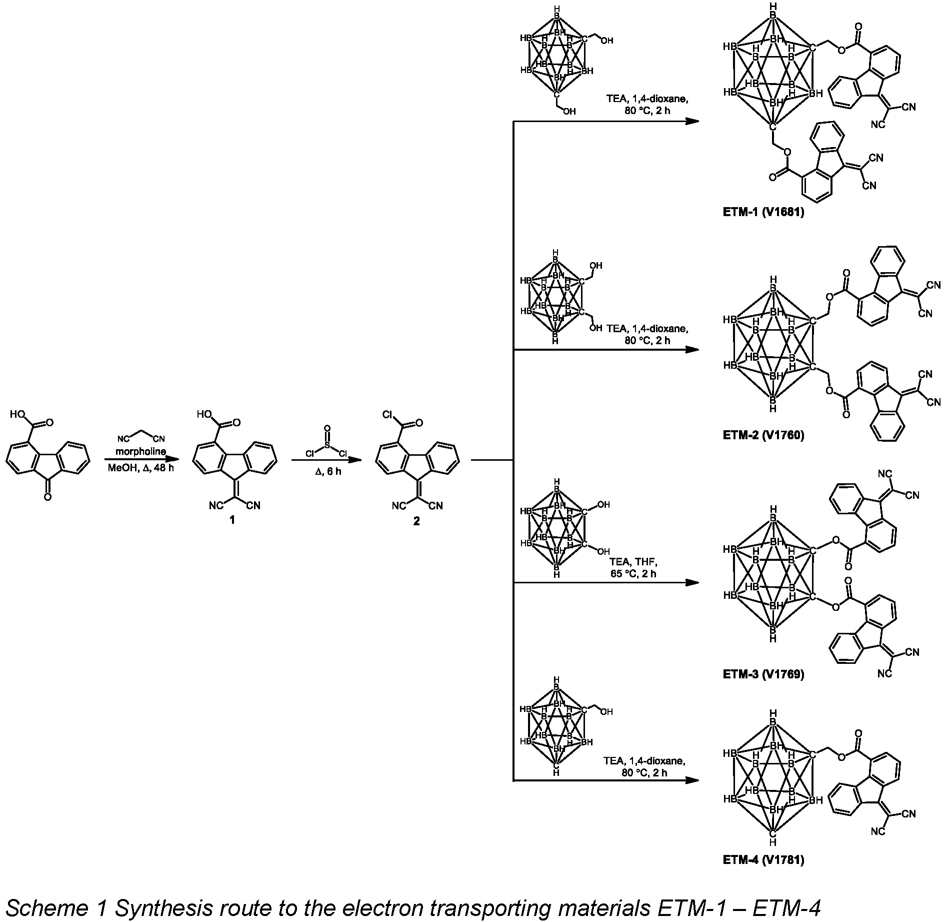

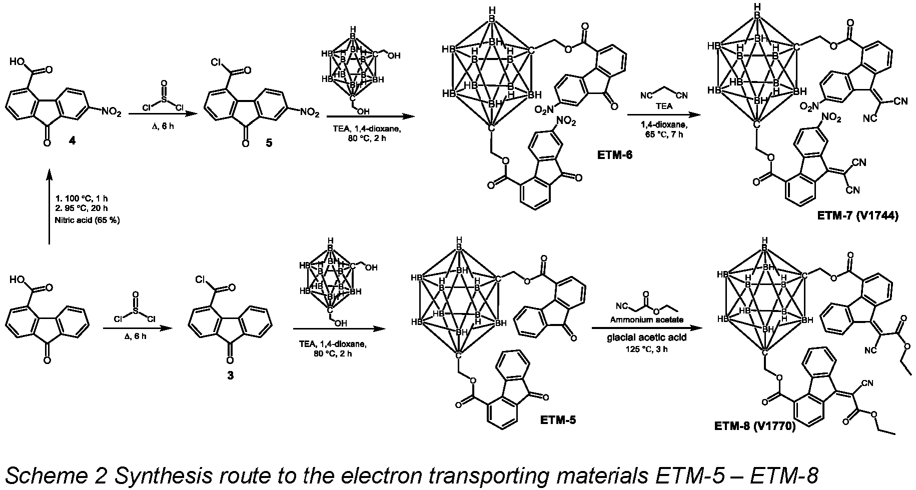

### - (4-Carboxy-9-fluorenylidene)malononitrile (1)

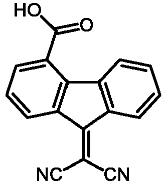

9-Fluorenone-4-carboxylic acid (5.00 g, 22.30 mmol, *TCl Europe*), methanol (90 ml), malononitrile (4.42 g, 66.90 mmol) and 2 drops of morpholine were added to a 250 ml roundbottomed flask equipped with a reflux condenser. The reaction mixture was magnetically stirred and refluxed for 48 h. Subsequently, the reaction mixture was cooled to room temperature and the orange solid product was filtered off. The crude product was stirred in boiling methanol (30 ml) for half an hour, and filtered hot, washed with methanol (3 ml), and then dried in vacuo at 70 °C for 24 h to provide 5.39 g of orange solid product (89 % yield).

### - (4-Chloroformyl-9-fluorenylidene)malononitrile (2)

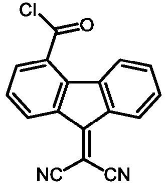

A mixture of (4-carboxy-9-fluorenylidene)malononitrile (1) (5.39 g, 19.80 mmol) and thionyl chloride (50 ml) was refluxed under argon for 6 h. After the termination of the reaction 50 ml of room temperature n-hexane was added to the boiling reaction mixture. The precipitated product was filtered, washed twice with 20 ml of room temperature n-hexane to obtain the product as orange crystals (5.00 g, 87 % yield).

### - 9-Oxo-9H-fluorene-4-carbonyl chloride (3)

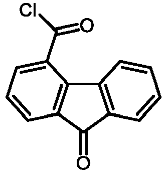

A mixture of 9-fluorenone-4-carboxylic acid (5.00 g, 22.30 mmol, *TCl Europe*) and thionyl chloride (25 ml) refluxed under argon for 6 h. Afterward, reaction mixture was cooled to room temperature and 25 ml of ice-cold n-hexane was added. The precipitated product was filtered, washed twice with 10 ml of ice-cold temperature n-hexane to obtain the product 3 as yellow crystals (5.10 g, 94 % yield).

### - 7-Nitro-9-fluorenone-4-carboxylic acid (4)

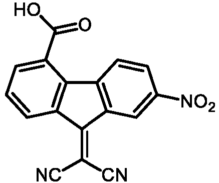

A suspension of 9-fluorenone-4-carboxylic acid (2.00 g, 8.92 mmol, *TCl Europe*) in 65% nitric acid (75 ml) was heated at 100 °C for 1 hour, followed by further heating at 95 °C for an additional 20 hours. After completion, the reaction mixture was allowed to cool to room temperature and subsequently poured into vigorously stirred ice-cold water. The resulting precipitate was isolated by vacuum filtration, washed thoroughly with distilled water (3 × 50 ml) and methanol (2 × 25 ml), and then dried in a 70 °C vacuum oven for 24 hours to afford the desired product as a yellow solid (1.15 g, 48% yield).

### - 7-Nitro-9-oxo-9H-fluorene-4-carbonyl chloride (5)

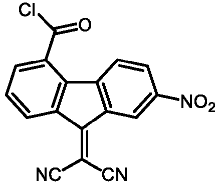

A mixture of 7-nitro-9-fluorenone-4-carboxylic acid (4) (4.40 g, 16.36 mmol) and thionyl chloride (70 ml) refluxed under argon for 6 h. After the termination of the reaction 70 ml of room temperature *n*-hexane was added to the boiling reaction mixture. The precipitated product was filtered, washed twice with 10 ml of room temperature *n*-hexane to obtain the product as yellow crystals (4.20 g, 89 % yield).

### - Preparation of Electron Transporting Material ETM-1 (V1681)

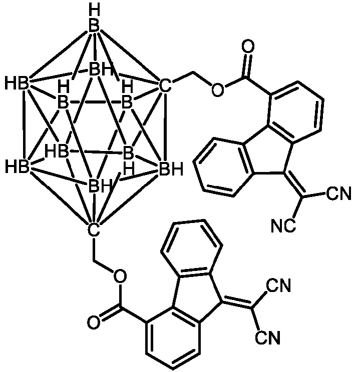

A solution of 1,7-bis(hydroxymethyl)-*m*-carborane (1.00 g, 4.90 mmol, from Katchem spol. s r. o., Czech Republic) and (4-chloroformyl-9-fluorenylidene)malononitrile (2) (3.56 g, 12.25 mmol) in anhydrous 1,4-dioxane (50 ml) was purged with argon for 20 minutes. Next, TEA (1.24 g, 12.25 mmol) was added, reaction mixture was heated to 80 °C and reaction carried out for 2 hours. After the termination of the reaction (TLC, acetone:*n*-hexane, 7:18, v:v), reaction mixture was filtered hot to remove the triethylamine hydrochloride salt by-product. The filtrate was evaporated to approximately 20 ml, and when 50 ml of methanol was added. The precipitated product was filtered and washed twice with 50 ml of room temperature methanol. Afterward, the crude product was dissolved in 260 ml of boiling toluene, filtered, then 260 ml of boiling methanol was added, and recrystallized by cooling the solution. The precipitated crystals were filtered, washed three times with 50 ml of methanol and dried in a 70 °C vacuum oven for 12 hours. Orange crystals (2.55 g, 73 % yield) of ETM-1 were obtained.

¹H NMR (400 MHz, CDCl₃) δ 8.58 (d, *J =* 7.9 Hz, 2H), 8.40 (d, *J =* 7.9 Hz, 2H), 8.22 (d, *J* = 7.9 Hz, 2H), 7.92 (d, *J* = 7.9 Hz, 2H), 7.48 (t, *J =* 7.8 Hz, 2H), 7.39 - 7.31 (m, 4H), 4.63 (s, 4H), 3.20 - 1.84 (m, 10H).

¹³C NMR (101 MHz, CDCl₃) δ 164.76, 159.70, 142.16, 140.25, 136.08, 135.76, 135.26, 134.62, 130.28, 129.90, 128.73, 126.65, 126.52, 126.09, 113.42, 113.30, 76.50, 72.47, 65.45.

FT-IR, ∪̅ (cm⁻¹): 3125, 3023 (aromatic CH); 2962, (aliphatic CH); 2598 (B-H); 2226 (C≡N); 1733 (C=O); 1568 (C=C).

### - Preparation of Electron Transporting Material ETM-2 (V1760)

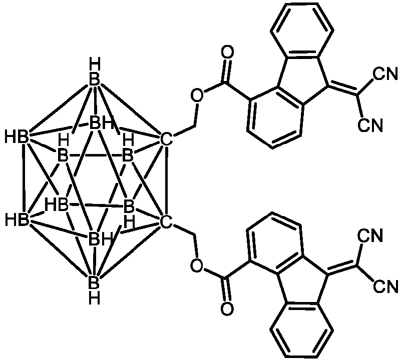

A solution of 1,2-bis(hydroxymethyl)-*o*-carborane (1.00 g, 4.90 mmol, from Katchem spol. s r. o., Czech Republic) and (4-chloroformyl-9-fluorenylidene)malononitrile (2) (3.56 g, 12.25 mmol) in anhydrous 1,4-dioxane (50 ml) was purged with argon for 20 minutes. Next, TEA (1.24 g, 12.25 mmol) was added, reaction mixture was heated to 80 °C and reaction carried out for 2 hours. After the termination of the reaction (TLC, acetone:*n*-hexane, 7:18, v:v), reaction mixture was filtered hot to remove the triethylamine hydrochloride salt by-product. The filtrate was evaporated to approximately 20 ml, and when 50 ml of methanol was added. The precipitated product was filtered and washed twice with 50 ml of room temperature methanol. Afterward, the crude product was dissolved in 600 ml of boiling 1,4-dioxane, filtered, then 400 ml of boiling methanol was added, and recrystallized by cooling the solution. The precipitated crystals were filtered, washed three times with 50 ml of methanol and dried in a 70 °C vacuum oven for 12 hours. Orange crystals (2.15 g, 62 % yield) of ETM-2 were obtained. FT-IR, ∪̅ (cm⁻¹): 3102 (aromatic CH); 2957, 2926, 2886, 2850 (aliphatic CH); 2588 (B-H); 2226 (C≡N); 1739 (C=O); 1565 (C=C).

### - Preparation of Electron Transporting Material ETM-3 (V1769)

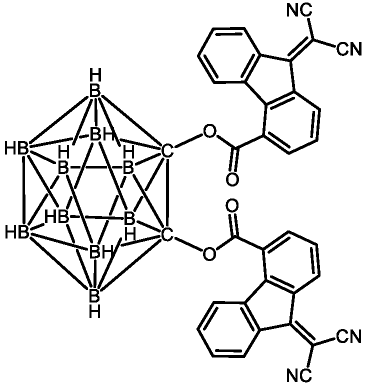

A solution of 1,2-dihydroxy-o-carborane (1.00 g, 5.70 mmol, from Katchem spol. s r. o., Czech Republic) and (4-chloroformyl-9-fluorenylidene)malononitrile (2) (4.14 g, 14.25 mmol) in anhydrous THF (60 ml) was purged with argon for 20 minutes. Next, TEA (1.44 g, 14.25 mmol) was added, reaction mixture was heated to 65 °C and reaction carried out for 2 hours. Subsequently, the reaction mixture was cooled to room temperature and the product was filtered off. The crude solid was stirred in boiling THF (50 ml) for 30 minutes, hot suspension was filtered, and the solid was washed with THF (2 × 50 ml). The resulting material was stirred in boiling methanol (100 ml) for 30 minutes, filtrated and washed with boiling methanol (3 × 50 ml). The final product ETM-3 was dried under vacuum at 70 °C for 12 hours, affording an orange solid (1.25 g, 32% yield). FT-IR, ∪̅ (cm⁻¹): 3105, 3075 (aromatic CH); 2956, 2856, 2853 (aliphatic CH); 2614 (B-H); 2225 (C≡N); 1796 (C=O); 1567 (C=C).

### - Preparation of Electron Transporting Material ETM-4 (V1781)

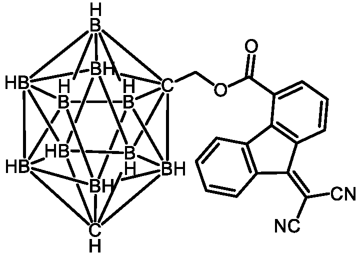

A solution of 1,7-dicarbadodecaborane(12)-1-methanol (1.00 g, 5.71 mmol, from Katchem spol. s r. o., Czech Republic) and (4-chloroformyl-9-fluorenylidene)malononitrile (2) (2.08 g, 7.14 mmol) in anhydrous THF (37 ml) was purged with argon for 20 minutes. Next, TEA (0.72 g, 7.14 mmol) was added, reaction mixture was heated to 80 °C and reaction carried out for 2 hours. After the termination of the reaction (TLC, acetone:*n*-hexane, 7:18, v:v), reaction mixture was filtered hot to remove the triethylamine hydrochloride salt by-product. The filtrate was evaporated to approximately 10 ml, and when 50 ml of methanol was added. The precipitated product ETM-4 was filtered and washed twice with 50 ml of room temperature methanol. Afterward, the crude product was dissolved in 40 ml of boiling toluene, filtered, then 40 ml of boiling *n*-hexane was added, and recrystallized by cooling the solution. The precipitated crystals were filtered, washed three times with 50 ml of methanol and dried in a 70 °C vacuum oven for 12 hours. Orange crystals (1.02 g, 42 % yield) of ETM-4 were obtained.

¹H NMR (400 MHz, THF-*d₈*) δ 8.65 (d, *J =* 8.3 Hz, 1H), 8.46 (d, *J* = 7.8 Hz, 1H), 8.31 (d, *J =* 7.7 Hz, 1H), 8.01 (d, *J =* 8.3 Hz, 1H), 7.59 - 7.49 (m, 2H), 7.45 (t, *J =* 7.8 Hz, 1H), 4.70 (s, 2H) 3.68 (s, 1H) 3.20 - 1.84 (m, 10H).

¹³C NMR (101 MHz, THF-*d₈*) δ 165.56, 159.72, 142.45, 141.21, 137.09, 136.38, 135.79, 135.62, 130.88, 130.26, 129.66, 127.45, 127.29, 127.00, 114.35, 114.31, 77.85, 74.01, 66.36, 56.98.

FT-IR, ∪̅ (cm⁻¹): 3105, 3064 (aromatic CH); 2972, (aliphatic CH); 2600 (B-H); 2225 (C≡N); 1734 (C=O); 1569 (C=C).

### - Preparation of Electron Transporting Material ETM-5

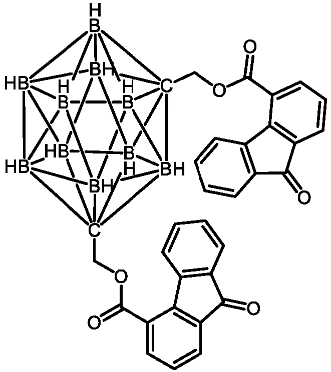

A solution of 1,7-bis(hydroxymethyl)-*m*-carborane (1.00 g, 4.90 mmol, from Katchem spol. s r. o., Czech Republic) and 9-oxo-9*H*-fluorene-4-carbonyl chloride (3) (2.97 g, 12.25 mmol) in anhydrous 1,4-dioxane (50 ml) was purged with argon for 20 minutes. Next, TEA (1.24 g, 12.25 mmol, 2.5 equiv.) was added, reaction mixture was heated to 80 °C and reaction carried out for 2 hours. After the termination of the reaction (TLC, acetone:*n*-hexane, 7:18, v:v), reaction mixture was filtered hot to remove the triethylamine hydrochloride salt by-product. The filtrate was evaporated to approximately 20 ml, and when 50 ml of methanol was added. The precipitated product was filtered and washed twice with 50 ml of room temperature methanol. Afterward, the crude product was dissolved in 100 ml of boiling 1,4-dioxane, filtered, then 100 ml of boiling methanol was added, and recrystallized by cooling the solution. The precipitated crystals were filtered, washed three times with 50 ml of methanol and dried in a 70 °C vacuum oven for 12 hours. The product ETM-5 was obtained as light greenish yellow crystals (2.53 g, 83 % yield). FT-IR, ∪̅ (cm⁻¹): 3078 (aromatic CH); 2957, 2896, 2853 (aliphatic CH); 2595 (B-H); 1713 (C=O); 1571 (C=C).

### - Preparation of Electron Transporting Material ETM-6

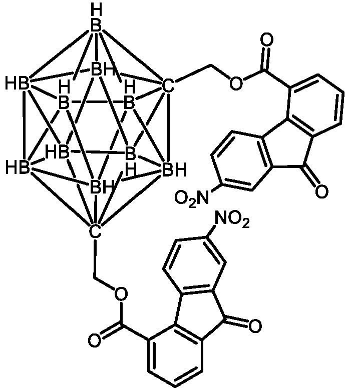

A solution of 1,7-bis(hydroxymethyl)-*m*-carborane (1.00 g, 4.90 mmol, from Katchem spol. s r. o., Czech Republic) and 7-nitro-9-oxo-9*H*-fluorene-4-carbonyl chloride (5) (3.52 g, 12.25 mmol) in anhydrous 1,4-dioxane (50 ml) was purged with argon for 20 minutes. Next, TEA (1.24 g, 12.25 mmol, 2.5 equiv.) was added, reaction mixture was heated to 80 °C and reaction carried out for 2 hours. After the termination of the reaction (TLC, acetone:*n*-hexane, 7:18, v:v), reaction mixture was filtered hot to remove the triethylamine hydrochloride salt by-product. The filtrate was evaporated to approximately 20 ml, and when 50 ml of methanol was added. The precipitated product was filtered and washed twice with 50 ml of room temperature methanol. Afterward, the crude product was dissolved in 150 ml of boiling 1,4-dioxane, filtered, then 150 ml of boiling methanol was added, and recrystallized by cooling the solution. The precipitated crystals were filtered, washed three times with 50 ml of methanol and dried in a 70 °C vacuum oven for 12 hours. Light greenish yellow crystals of ETM-6 (2.42 g, 70 % yield) were obtained. FT-IR, ∪̅ (cm⁻¹): 3125, 3082, 3019 (aromatic CH); 2977, 2889 (aliphatic CH); 2583 (B-H); 1722 (C=O); 1576 (C=C); 1527, 1341 (N=O).

### - Preparation of Electron Transporting Material ETM-7 (V1744)

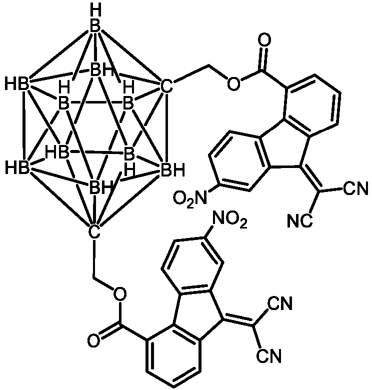

Compound ETM-6 (2.00 g, 2.80 mmol) and malononitrile (1.85 g, 28.00 mmol) were dissolved in anhydrous 1,4-dioxane (46 ml) and was purged with argon for 20 minutes. Then 20 drops of TEA were added and the solution was heated to 65 °C under argon atmosphere for 7 hours. After the termination of the reaction (TLC, acetone:*n*-hexane, 7:18, v:v), reaction mixture was cooled to room temperature. The crude product was isolated by filtration and dissolved in 250 ml of boiling tetrahydrofuran, filtered, then 125 ml of boiling methanol was added, and recrystallized by cooling the solution. The precipitated crystals were filtered, washed three times with 50 ml of methanol and dried in a 70 °C vacuum oven for 12 hours. Pile yellow crystals (1.10 g, 49 % yield) of the product ETM-7 were obtained. FT-IR, ∪̅ (cm⁻¹): 3126, 3091 (aromatic CH); 2962, (aliphatic CH); 2606 (B-H); 2227 (C≡N); 1733 (C=O); 1571 (C=C); 1531, 1341 (N=O).

### - Preparation of Electron Transporting Material ETM-8 (V1770)

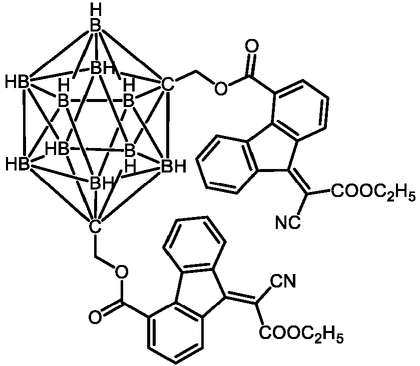

Compound ETM-5 (2.00 g, 3.24 mmol) and ethyl 2-cyanoacetate (14.66 g, 129.60 mmol) were dissolved in glacial acetic acid (15 ml) and purged with argon for 20 minutes. Then (1.25 g, 16.20 mmol) of ammonium acetate were added and the solution was heated to 125 °C under argon atmosphere for 3 hours. After the termination of the reaction (TLC, acetone:*n*-hexane, 1:4, v:v), reaction mixture was cooled to room temperature. 30 ml of mixture water and methanol (1:1, v:v) was added. The mixture was stirred for 1 hour at room temperature. The precipitated resin was purified by column chromatography (acetone:n-hexane, 1:9, v:v) to obtain ETM-8 as yellow solid (0.83 g, 32% yield).

¹H NMR (400 MHz, THF-*d₈*) δ 8.77 (d, *J* = 7.9 Hz, 1H), 8.59 (d, *J* = 7.5 Hz, 1H), 8.22 (d, *J* = 7.5 Hz, 2H), 8.08 (d, *J =* 7.8 Hz, 1H), 7.93 - 7.83 (m, 3H), 7.47 - 7.37 (m, 4H), 7.33 - 7.24 (m, 2H), 4.72 (s, 4H), 4.49 (q, *J =* 7.0 Hz, 4H), 3.20 - 1.84 (m, 10H), 1.41 (t, *J* = 7.0 Hz, 6H).

¹³C NMR (101 MHz, THF-*d₈*) δ 165.97, 163.11, 163.04, 152.33, 152.03, 142.08, 142.01, 140.82, 140.79, 138.33, 137.24, 136.97, 135.96, 134.70, 133.67, 133.59, 131.28, 130.28, 129.85, 129.60, 128.94, 128.44, 127.59, 126.88, 126.81, 126.50, 126.37, 126.24, 116.65, 101.72, 101.64, 74.16, 66.07, 64.12, 14.20.

FT-IR, ∪̅ (cm⁻¹): 3052 (aromatic CH); 2980, 2963, 2937, 2901, 2872 (aliphatic CH); 2594 (B-H); 2209 (C≡N); 1723 (C=O); 1574 (C=C).

### - Preparation of Electron Transporting Material ETM-9

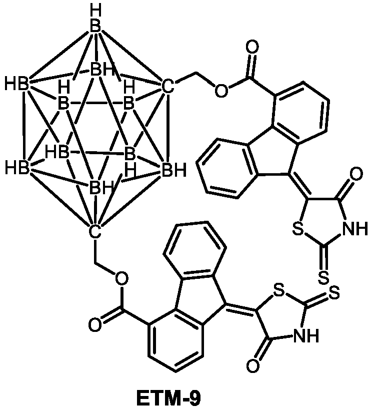

Compound ETM-9 can be prepared by a similar method to the preparation of Compound ETM-8 except rhodanine (available from TCI Europe) replaces 2-cyanoacetate.

### - Preparation of Electron Transporting Material ETM-10

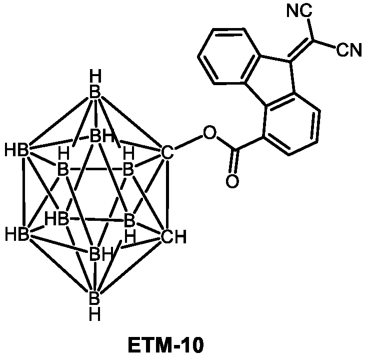

Compound ETM-10 can be prepared by a similar method to the preparation of Compound ETM-3 except 1-hydroxy-o-carborane (available from Katchem spol. s r. o., Czech Republic) replaces 1,2-dihydroxy-o-carborane, and twice lower amount of (4-chloroformyl-9-fluorenylidene)-malononitrile (2) and TEA should be taken.

### - Preparation of Electron Transporting Material ETM-11

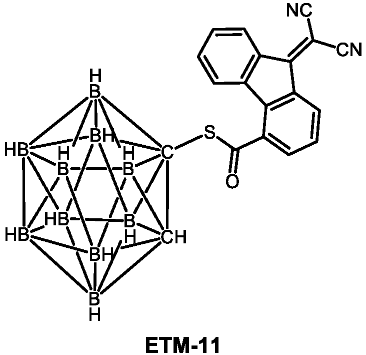

Compound ETM-11 can be prepared by a similar method to the preparation of Compound ETM-3 except 1-mercapto-o-carborane (available from Katchem spol. s r. o., Czech Republic) replaces 1,2-dihydroxy-o-carborane, and twice lower amount of (4-chloroformyl-9-fluorenylidene)-malononitrile (2) and TEA should be taken.

### - Preparation of Electron Transporting Material ETM-12

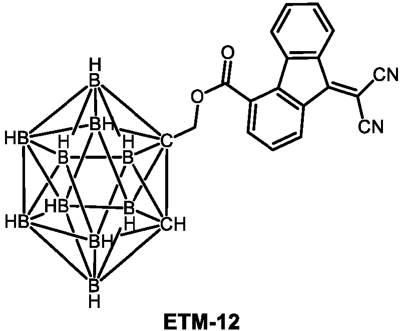

Compound ETM-12 can be prepared by a similar method to the preparation of Compound ETM-3 except 1-hydroxymethyl-o-carborane (available from Katchem spol. s r. o., Czech Republic) replaces 1,2-dihydroxy-o-carborane, and twice lower amount of (4-chloroformyl-9-fluorenylidene)-malononitrile (2) and TEAshould be taken.

### - Preparation of Electron Transporting Material ETM-13

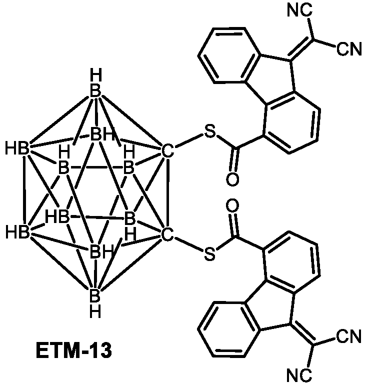

Compound ETM-13 can be prepared by a similar method to the preparation of Compound ETM-3 except 1,2-dimercapto-o-carborane (available from Katchem spol. s r. o., Czech Republic) replaces 1,2-dihydroxy-*o*-carborane.

### - Preparation of Electron Transporting Material ETM-14

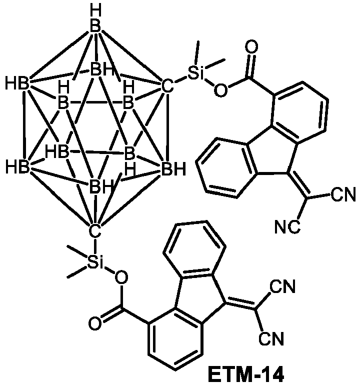

Compound ETM-13 can be prepared by a similar method to the preparation of Compound ETM-1 except 1,7-bis(hydroxydimethylsilyl)-*m*-carborane (available from Katchem spol. s r. o., Czech Republic) replaces 1,7-bis(hydroxymethyl)-*m*-carborane.

### - Preparation of Electron Transporting Material ETM-15

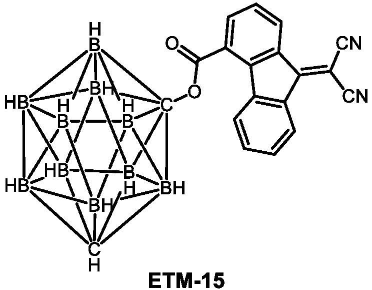

Compound ETM-15 can be prepared by a similar method to the preparation of Compound ETM-1 except 1-hydroxymethyl-m-carborane (available from Katchem spol. s r. o., Czech Republic) replaces 1,7-bis(hydroxymethyl)-*m*-carborane, and twice lower amount of (4-chloroformyl-9-fluorenylidene)-malononitrile (2) and TEA should be taken.

### - Preparation of Electron Transporting Material ETM-16

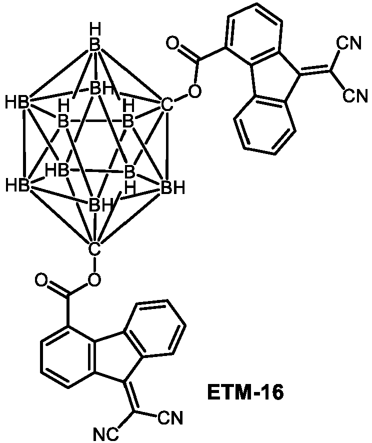

Compound ETM-16 can be prepared by a similar method to the preparation of Compound ETM-1 except 1,7-dihydroxymethyl-m-carborane (available from Katchem spol. s r. o., Czech Republic) replaces 1,7-bis(hydroxymethyl)-*m*-carborane.

### - Preparation of Electron Transporting Material ETM-17

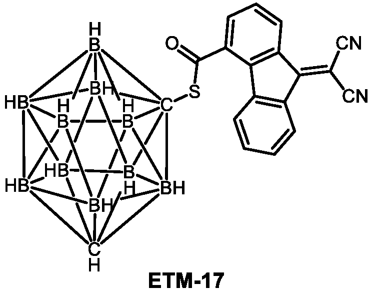

Compound ETM-17 can be prepared by a similar method to the preparation of Compound ETM-4 except 1-mercapto-m-carborane (available from Katchem spol. s r. o., Czech Republic) replaces 1,7-dicarbadodecaborane(12)-1-methanol.

### - Preparation of Electron Transporting Material ETM-18

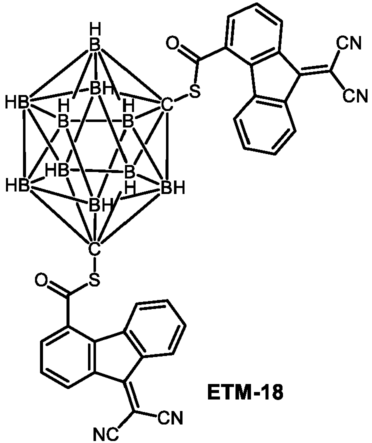

Compound ETM-18 can be prepared by a similar method to the preparation of Compound ETM-1 except 1,7-dimercapto-m-carborane (available from Katchem spol. s r. o., Czech Republic) replaces 1,7-bis(hydroxymethyl)-*m*-carborane.

### - Preparation of Electron Transporting Material ETM-19

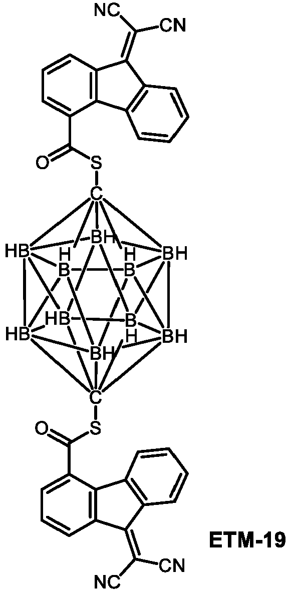

Compound ETM-19 can be prepared by a similar method to the preparation of Compound ETM-1 except 1,12-dimercapto-*p*-carborane1,7-dimercapto-*m*-carborane (available from Katchem spol. s r. o., Czech Republic) replaces 1,7-bis(hydroxymethyl)-*m*-carborane.

### - Preparation of Electron Transporting Material ETM-20

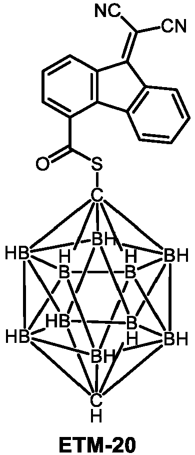

Compound ETM-20 can be prepared by a similar method to the preparation of Compound ETM-4 except 1-mercapto-p-carborane (available from Katchem spol. s r. o., Czech Republic) replaces 1,7-dicarbadodecaborane(12)-1-methanol.

### - Preparation of Electron Transporting Material ETM-21

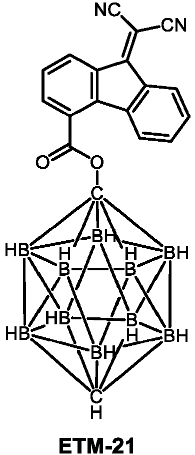

Compound ETM-21 can be prepared by a similar method to the preparation of Compound ETM-4 except 1-hydroxy-p-carborane (available from Katchem spol. s r. o., Czech Republic) replaces 1,7-dicarbadodecaborane(12)-1-methanol.

### - Preparation of Electron Transporting Material ETM-22

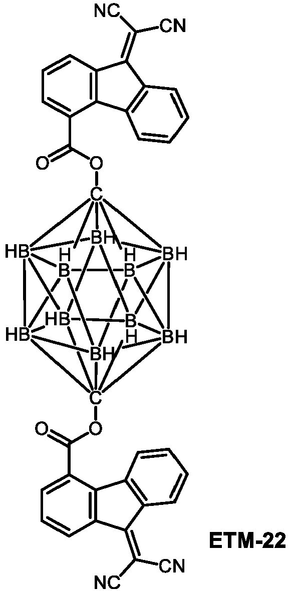

Compound ETM-22 can be prepared by a similar method to the preparation of Compound ETM-1 except 1,12-dihydroxy-p-carborane (available from Katchem spol. s r. o., Czech Republic) replaces 1,7-bis(hydroxymethyl)-*m*-carborane.

### - Preparation of Electron Transporting Material ETM-23

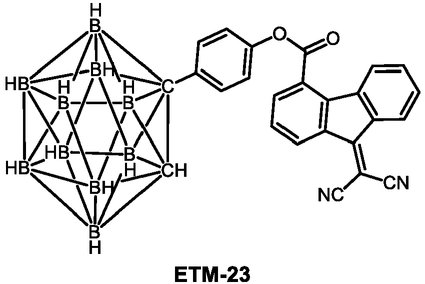

Compound ETM-23 can be prepared by a similar method to the preparation of Compound ETM-4 except o-carboranylphenol (available according to synthesis procedure described in ref.^{[2]}) replaces 1,7-dicarbadodecaborane(12)-1-methanol.

### - Preparation of Electron Transporting Material ETM-24

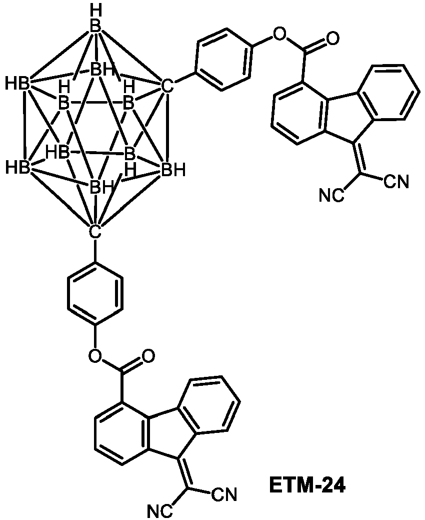

Compound ETM-24 can be prepared by a similar method to the preparation of Compound ETM-1 except 4,4'-(1,7-dicarbadodecaborane(12)-1,7-diyl)bis[phenol] (available according to synthesis procedure described in ref.^{[3]}) replaces 1,7-bis(hydroxymethyl)-*m*-carborane.

### - Preparation of Electron Transporting Material ETM-25

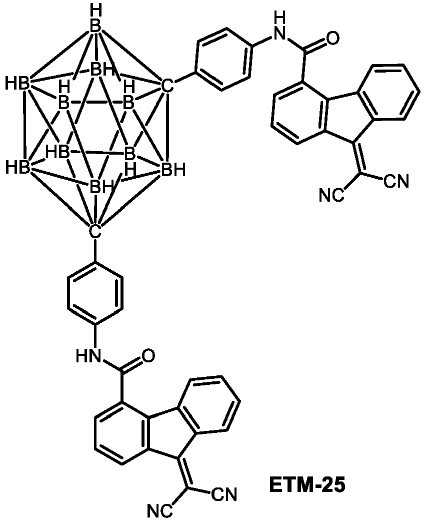

Compound ETM-25 can be prepared by a similar method to the preparation of Compound ETM-1 except 4,4'-(1,7-dicarbadodecaborane(12)-1,7-diyl)bis[benzenamine] (available according to synthesis procedure described in ref.^{[4]}) replaces 1,7-bis(hydroxymethyl)-*m-*carborane.

### - Preparation of Electron Transporting Material ETM-26

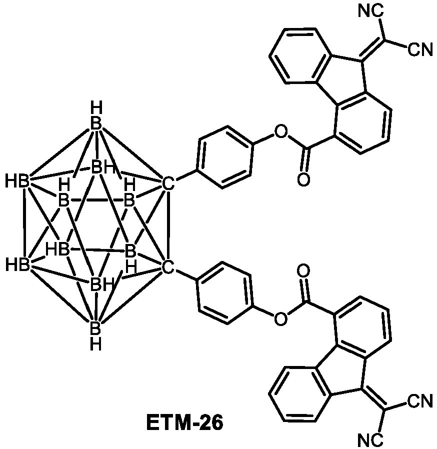

Compound ETM-26 can be prepared by a similar method to the preparation of Compound ETM-1 except 1,2-bis(4-hydroxyphenyl)-*o*-carborane (available from A2B Chem, San Diego, CA 9219, United States) replaces 1,7-bis(hydroxymethyl)-*m*-carborane.

### - Preparation of Electron Transporting Material ETM-27

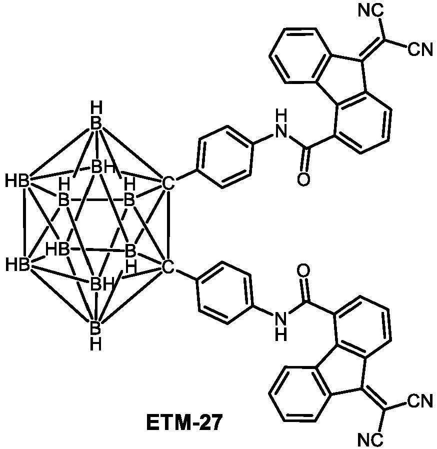

Compound ETM-27 can be prepared by a similar method to the preparation of Compound ETM-1 except 1,2-bis(4-aminophenyl)-*o*-carborane (available according to synthesis procedure described in ref.^{[5]}) replaces 1,7-bis(hydroxy-methyl)-*m*-carborane.

### - Preparation of Electron Transporting Material ETM-28

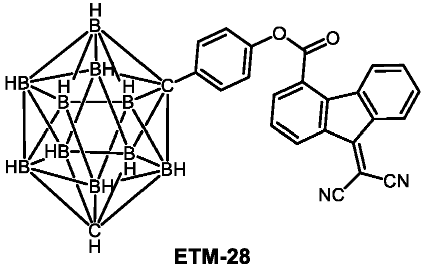

Compound ETM-28 can be prepared by a similar method to the preparation of Compound ETM-4 except 4-(1,7-dicarbadodecaboran(12)-1-yl)phenol (available according to synthesis procedure described in ref.^{[6]}) replaces 1,7-dicarbadodecaborane(12)-1-methanol.

### - Preparation of Electron Transporting Material ETM-29

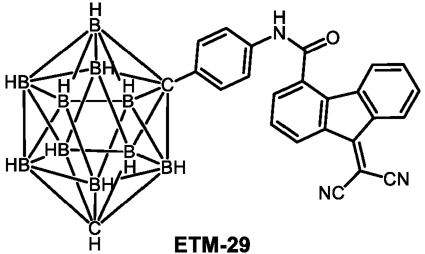

Compound ETM-29 can be prepared by a similar method to the preparation of Compound ETM-4 except 1-(4-aminophenyl)-m-carborane (available according to synthesis procedure described in ref.^{[7]}) replaces 1,7-dicarbadodecaborane(12)-1-methanol.

### - Preparation of Electron Transporting Material ETM-30

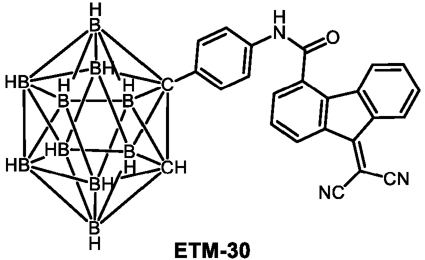

Compound ETM-30 can be prepared by a similar method to the preparation of Compound ETM-4 except 4-(1,2-dicarbadodecaboran(12)-1-yl)benzenamine (available according to synthesis procedure described in ref.^{[8]}) replaces 1,7-dicarbadodecaborane(12)-1-methanol.

### - Preparation of Electron Transporting Material ETM-31

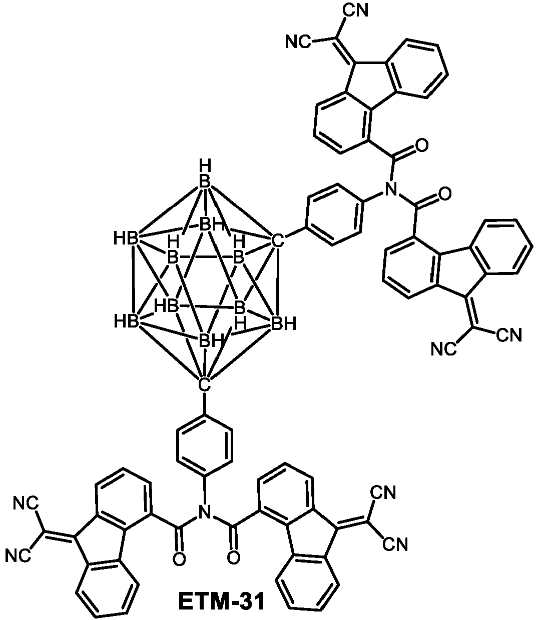

Compound ETM-31 can be prepared by a similar method to the preparation of Compound ETM-1 except 1,7-bis(4-aminophenyl)-*m*-carborane (available according to synthesis procedure described in ref.^{[4]}) replaces 1,7-bis(hydroxymethyl)-*m*-carborane and twice bigger amount of (4-chloroformyl-9-fluorenylidene)malononitrile (2) and TEA should be taken.

### - Preparation of Electron Transporting Material ETM-32

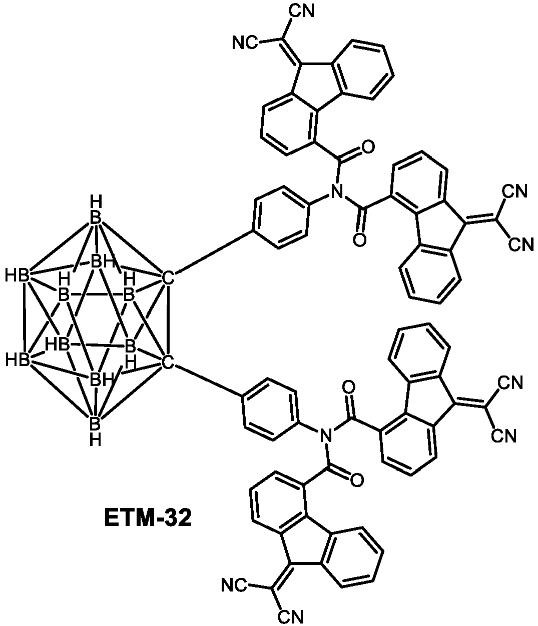

Compound ETM-32 can be prepared by a similar method to the preparation of Compound ETM-1 except 1,2-bis(4-aminophenyl)-*o*-carborane (available according to synthesis procedure described in ref.^{[5]}) replaces 1,7-bis(hydroxy-methyl)-*m*-carborane and twice bigger amount of (4-chloroformyl-9-fluorenylidene)-malono-nitrile (2) and TEA should be taken.

### - Preparation of Electron Transporting Material ETM-33

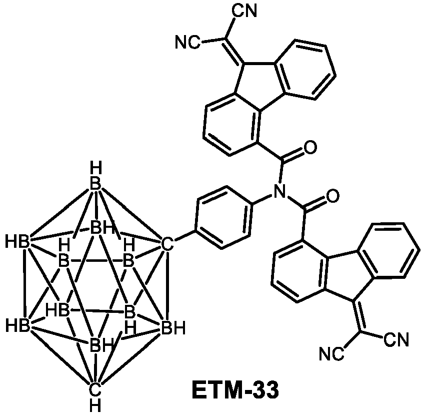

Compound ETM-33 can be prepared by a similar method to the preparation of Compound ETM-4 except 1-(4-aminophenyl)-m-carborane (available according to synthesis procedure described in ref.^{[7]}) replaces 1,7-dicarbadodecaborane(12)-1-methanol and twice bigger amount of (4-chloroformyl-9-fluorenylidene)malononitrile (2) should be taken.

### - Preparation of Electron Transporting Material ETM-34

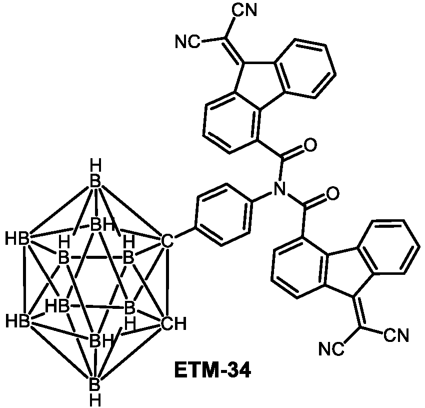

Compound ETM-34 can be prepared by a similar method to the preparation of Compound ETM-4 except 4-(1,2-dicarbadodecaboran(12)-1-yl)benzenamine (available according to synthesis procedure described in ref.^{[8]}) replaces 1,7-dicarbadodecaborane(12)-1-methanol and twice bigger amount of (4-chloroformyl-9-fluorenylidene)malononitrile (2) and TEA should be taken.

### - Preparation of Electron Transporting Material ETM-35

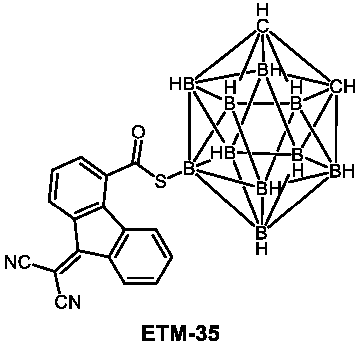

Compound ETM-35 can be prepared by a similar method to the preparation of Compound ETM-4 except 9-mercapto-o-carborane (available from Katchem spol. s r. o., Czech Republic) replaces 1,7-dicarbadodecaborane(12)-1-methanol.

### - Preparation of Electron Transporting Material ETM-36

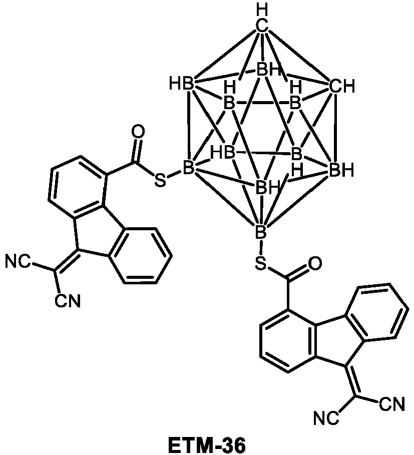

Compound ETM-36 can be prepared by a similar method to the preparation of Compound ETM-1 except 9,12-dimercapto-o-carborane (available from Katchem spol. s r. o., Czech Republic) replaces 1,7-bis(hydroxymethyl)-*m*-carborane.

### - Preparation of Electron Transporting Material ETM-37

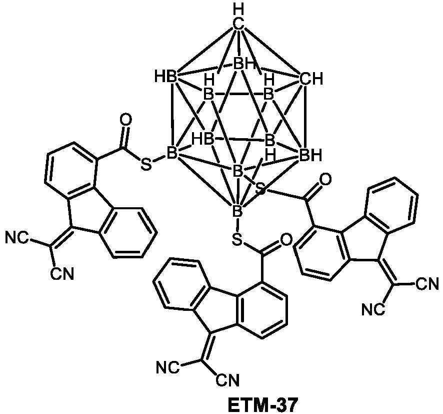

Compound ETM-37 can be prepared by a similar method to the preparation of Compound ETM-4 except 8,9,12-trimercapto-*o*-carborane (available from Katchem spol. s r. o., Czech Republic) replaces 1,7-dicarbadodecaborane(12)-1-methanol and three times the amount of (4-chloroformyl-9-fluorenylidene)malononitrile (2) and TEA should be taken.

### Example 2: Fabrication and characterisation of solar cells

### Fabrication of single-junction solar cells and solar cell partial stacks:

Glass/indium tin oxide (ITO) (for solar cell partial stacks: Automatic Research GmbH, for solar cells: Suzhou ShangYang Solar Technology Co.,Ltd, TX11-12AR) or glass substrates were cleaned by ultra-sonication in H₂O with detergent (Hellmanex, 2%), H₂O, acetone, and IPA for 10 min each, including DI water rinsing between the steps.

For the self-assembled monolayer (SAM) hole transport layer (HTL), (4-(3,6-Diphenyl-9H-carbazol-9-yl)butyl)phosphonic acid (Ph-4PACz) was dissolved in in ethanol (1 mg/ml). The solution was then spin-coated in a nitrogen-filled glovebox at 3000 rpm for 20 s and annealed at 100 °C for 10 min. All following spin-coating processes were also conducted in nitrogen gloveboxes.

For the 1.4M triple-cation triple-halide (3Hal) perovskite (Cs_{0.22}FA_{0.78}Pb(I_{0.85}Br_{0.15})₃ + 5% MAPbCl₃) (1.68 eV) precursor, a Cs_{0.22}FA_{0.78}Pb(Br_{0.15} I_{0.85})₃ solution was prepared in a mixture of DMF and DMSO (volume ratio DMF:DMSO 3:1) and added to the MAPbCl₃ solids in a second step. The solution was spin-coated at 5000 rpm for 45 s, using 5 s acceleration and 250 µl anisole as antisolvent at 25 s from the beginning of the spin-coating process. The perovskite film was annealed at 100 °C for 20 min.

For solar cells/solar cell partial stacks with C₆₀ as ETM, 16 nm C₆₀ was thermally evaporated (pressure of 3 · 10⁻⁶ - 1 · 10⁻⁶ mbar, 300 - 400 °C). For solar cells/solar cell partial stacks with the herein presented alternative ETMs the following deposition procedures were conducted:
- V1681 evaporation: 4 nm of the material was thermally evaporated at a pressure of 3 . 10⁻⁶ - 1 . 10⁻⁶ mbar and a temperature of 150 - 180 °C.
- V1760 evaporation: 4 nm of the material was thermally evaporated at a pressure of 3 . 10⁻⁶ - 1 . 10⁻⁶ mbar and a temperature of 150 - 180 °C.
- V1744 evaporation: 4 nm of the material was thermally evaporated at a pressure of 3 . 10⁻⁶ - 1 . 10⁻⁶ mbar and a temperature of 180 - 200 °C.
- V1681 spin-coating: V1681 was dissolved in chlorobenzene (4 mg/ml) and filtered through a 2 µm PTFE filter. The material was deposited via spin-coating (3 s acceleration, 27 s at 4000 rpm) after statically dropping the solution on the sample.
- V1760 spin-coating: V1760 was dissolved in chlorobenzene (4 mg/ml) and filtered through a 2 µm PTFE filter. The material was deposited via spin-coating (3 s acceleration, 27 s at 4000 rpm) after statically dropping the solution on the sample.
- V1744 spin-coating: V1744 was dissolved in chlorobenzene (4 mg/ml) and filtered through a 2 µm PTFE filter. The material was deposited via spin-coating (3 s acceleration, 27 s at 4000 rpm) after statically dropping the solution on the sample.
- V1722 spin-coating: V1722 was dissolved in ethanol (5 mg/ml) and filtered through a 2 µm PTFE filter. The material was deposited via spin-coating at a rotation speed of 4000 rpm (3 s acceleration, 27 s at 4000 rpm).
- V1746 spin-coating: V1746 was dissolved in ethanol (5 mg/ml) and filtered through a 2 µm PTFE filter. The material was deposited via spin-coating at a rotation speed of 4000 rpm 3 s acceleration, 27 s at 4000 rpm).
- *Ortho*-carborane (o-CB) spin-coating: o-CB was dissolved in chlorobenzene (5 mg/ml) and filtered through a 2 µm PTFE filter. The material was deposited via spin-coating (3 s acceleration, 27 s at 4000 rpm) after statically dropping the solution on the sample.
- *Meta*-carborane (*m*-CB) spin-coating: *m*-CB was dissolved in chlorobenzene (5 mg/ml) and filtered through a 2 µm PTFE filter. The material was deposited via spin-coating (3 s acceleration, 27 s at 4000 rpm) after statically dropping the solution on the sample.

SnOₓ buffer layers were deposited by atomic layer deposition (ALD) in an Arradiance GEMStar reactor. Tetrakis(dimethylamino)tin(IV) (TDMASn) was used as the Sn precursor and was held at 60 °C in a stainless-steel container. Water was used as an oxidant, and was delivered from a stainless-steel container without active heating, whereas the precursor and oxidizer delivery manifold was heated to 115 °C. For the deposition at 80 °C, the TDMASn/purge/H₂O/purge times were 1 s/10 s/0.2 s/15 s for the first 25 cycles, 1 s/10 s/0.3 s/15 s for the next 25 cycles and 1 s/10 s/0.4 s/15 s for the last 25 cycles (total of 75 ALD cycles) with corresponding nitrogen flows of 30 sccm/90 sccm/90 sccm/90 sccm.

The ca. 0.18 cm² cell area of the p-i-n perovskite solar cells was determined by the overlap of ITO and the barbell-shaped Ag contact (100 nm thickness) that was thermally evaporated using shadow masks.

### Fabrication of perovskite/silicon tandem solar cells:

Silicon heterojunction (SHJ) bottom cells were fabricated by the Competence Centre Photovoltaics Berlin (PVComB) and, if not stated otherwise, following a fabrication process as reported in ref.^{[9]} and ref.^{[10]}. In the following, the manufacturing process is briefly summarized. Basis for the SHJ bottom cells were 280 µm thick float zone (FZ) c-Si wafers with a resistivity of ~1-5 Ωcm. The rear side of the wafers had a random pyramid texture that was obtained by wet texturing. The front side, however, was kept planar. On both sides of the wafers an intrinsic amorphous silicon (a-Si:H(i)) layer with a thickness of 5 nm was grown as passivation of the c-Si surface. On the rear side, a 5 nm thick p-doped amorphous silicon (a-Si:H(p)) layer was applied as a hole-selective layer. On the polished front side, an n-doped nanocrystalline silicon oxide layer (nc-SiOₓ:H(n)) of 100 nm functions as the electron-selective layer. The recombination layer at the front side further consisted of a 20 nm doped indium oxide transparent conductive oxide (TCO) (99% indium oxide from newSCOT target from ANP Corp.). The rear side contact was composed of 180 nm doped indium oxide TCO (99% indium oxide from newSCOT target from ANP Corp.) and 400 nm silver.

For the fabrication of the perovskite top cell in perovskite/silicon tandem solar cells, the same deposition procedures were employed for the HTL, the 1.68 eV 3Hal perovskite absorber, ETM, and SnOₓ buffer layer as those used in the single-junction device architecture. The 40 nm IZO electrode in the monolithic perovskite/silicon tandem solar cells was prepared by RF magnetron sputtering. A 4-inch sputter target with a composition of 90 wt.% In₂O₃ 10 %wt. ZnO (robeko GmbH & Co. KG) was used. The process pressure was 6 · 10⁻³ mbar. Furthermore, a RF power of 150 W (1.85 W/cm²) and an argon/oxygen gas flow with an oxygen ratio of 0.167 %vol. was used. On top of the IZO electrode, a 500 nm silver frame with grid fingers was thermally evaporated at pressures around 5 · 10⁻⁶ mbar and a final deposition rate of 6 Å/s. The applied shadow mask had 6 openings for grid fingers with the size 0.035 x 3.95 mm². Together with the IZO electrode layer the silver frame defined an active area of 1.08 cm². As a final step, a 100 nm LiF anti-reflection coating (ARC) was thermally evaporated on the active area.

### Characterisation of solar cells

### Current density-voltage (J-V) measurements:

*J-V* characteristics of perovskite single-junction solar cells were conducted in N₂ atmosphere and under 1-Sun AM1.5g equivalent illumination (1000 Wm⁻²) from an Oriel LCS-100 class ABB sun simulator or an LED-based sun simulator Sinus 300 from Wavelabs. The illumination intensity was calibrated to the *J*_{SC} of a filtered silicon reference cell. For obtaining the *J-V* scans the voltage was swept in reverse (*V*_{OC} to *J*_{SC}) and forward direction (*J*_{SC} to *V*_{OC}) between 1.3 and -0.02 V in 0.02 V steps and with an integration time of 20 ms and settling time of 20 ms. The scans were recorded by a Keithley 2400 digital source measure unit, which was controlled by custom LabView software and using a two-wire arrangement. The devices were kept at a constant temperature of 25 °C. The measurements were conducted using shadow masks to define and aperture area of 0.1 cm².

### Photoluminescence (PL):

For the PL measurements of solar cell partial stacks in N₂ atmosphere, a prototype of "LuQY Pro" setup by QYB in a glovebox was used. In this setup, a 532 nm wavelength laser was directed over a parabolic mirror onto the sample. The PL from the sample was collected over two serial plano-convex lenses via a fibre to a spectrometer (QE Pro, Ocean Insight). The signal was compiled using a software by Quantum Yield Berlin (QYB). The laser (Insaneware) had an excitation fluence of approximately 1-Sun equivalent and illuminated an area of 0.14 cm² on the sample. The samples were illuminated from the substrate side. The calculation of the QFLS was estimated from the generalized Planck law using the high-energy tail method^{[11]} .

### Transient Photoluminescence (trPL):

The measurements were performed with a home-built confocal PL setup in air on encapsulated samples. The setup featured an "80:20"- "transmission:reflection"-beam splitter to separate the excitation and detection paths. A 700 nm diode laser (IB-705-B laser head with Taiko driver, Picoquant) with a pulse duration of ≈100 ps and a repetition rate of 10 kHz was used for excitation from the substrate side. The laser beam was passed through a cleanup filter (FF01-700/13-25, Semrock) and the energy of the laser beam was tuned by a linear-gradient neutral density filter to ≈0.2 µW (=0.8 µW readout on power meter). An off-axis parabolic mirror with 5 cm focal length has been used for the focus and PL collection. The laser spot size is a circle with a ≈250 µm diameter. A silicon single-photon avalanche diode (Laser Components COUNT50) has been employed for the PL detection, and the signal was cut by a 715 nm longpass filter (FF01-715/LP-25, Semrock). The PL count and decay histogram were recorded by a TimeHarp260 Nano time-correlated single photon counting module (Picoquant).

The decay curve was fitted by an arbitrary sum of exponential slopes to compute the differential lifetime. The differential lifetime was calculated via^{[12]}: ${τ}_{diff} = - {\left[\frac{d \left(ln\left(trPL\left(t\right)\right)\right)}{dt}\right]}^{- 1}$ (1)

For differential lifetimes plots, one has to estimate the QFLS. For this we use three relations: $PL = {k}_{rad} np = {k}_{rad} {n}^{2}$ (2) $QFLS = kTln \left(\frac{PL}{PL \left(0\right)}\right) + kTln \left(\frac{n {\left(0\right)}^{2}}{{n}_{i}^{2}}\right) with {n}_{i}^{2} = {N}_{c} {N}_{v} {e}^{\frac{- Eg}{kT}}$ (3)

With the assumption of *N*_{c} = *N*ᵥ = 2 · 10¹⁸ cm⁻³. This value determines the starting QFLS(0). The other values are determined by the normalized PL decay PL/PL(0), respectively.

### Transient surface photovoltage (trSPV)

trSPV measurements were carried out on an in-house built setup. The samples were laserexcited from the encapsulation glass side with a tuneable pumped pulse laser (Nd:YAG Laser, EKSPLA, NT230-50-SH/SF-SCU-2H). For the measurements in this work, excitation wavelength of 700 nm and a pulse time of 3-6 ns at a frequency of 2 Hz were used. The laser fluence was controlled via neutral density filters and adjusted to yield charge carrier densities equivalent to 1 Sun. A total of 20 curves were recorded and averaged. The transients were measured with an oscilloscope card (Gage, CSE 1622- 4GS, 200 MS s⁻¹) using an in-house developed for logarithmic read-out.

### Photoelectron spectroscopy (PES):

He-I ultra-violet photoelectron spectroscopy (UPS) was performed in an ultra-high vacuum (UHV) system (base pressure <10⁻¹⁰ mbar) by SPECS Surface Nano Analysis GmbH. Via an inert transfer the samples consisting of glass/ITO/3Hal perovskite and glass/ITO/15 nm V1681 were directly loaded to a glove box attached to UHV.

UPS measurements with He-I excitation (hv = 21.2 eV) were performed, with a survey scan followed by a more detailed scan of the highest occupied molecular orbital (HOMO) region and a control survey scan. A hemispheric electron analyser (PHOIBOS150) with a 1D-DLD detector was used with a pass energy of 2.25 eV in low angular diffraction lens mode with entrance slit 0.8x20c, an open exit slit and a bias voltage between the detector and the exit slit of -0.5 V. To investigate the secondary electron cut-off (SECO) a bias voltage between the sample and the analyser of -7 V was applied.

The secondary electron cut-off (SECO) and HOMO edge were obtained by a linear extrapolation of the edge of the SECO and HOMO and the respective intercept with the background signal. The spectra of the perovskite absorber were corrected for the appearance of satellite features in the HOMO/band gap region beforehand.

### Contact Angle Measurements:

A Krüss 100S drop shape analyser was used to perform contact angle measurements based on the sessile drop method. The measurements were conducted at room temperature in air and using two different liquids, i.e. water as a polar liquid and diiodo-methane as a highly dispersive liquid. The surface free energy and respective disperse and polar parts for each sample were calculated based on the mean contact angles with water and diiodo-methane using the Owens-Wendt-Rabel-Kaelble (OWRK) method^{[13,14]}.

### Scanning electron microscopy (SEM):

Top-view SEM measurements of solar cell partial stacks were performed using a Zeiss Merlin Field Emission SEM with a Gemini 2 optical column equipped with an InLens detector for secondary electrons. An acceleration voltage of 5 kV and magnification of 80 K was used for all images.

### Ultraviolet-visible-near-infrared (UV-Vis-NIR) spectroscopy:

A Perkin Elmer Lambda 1050+ spectrophotometer was used to obtain the spectral transmission and reflection of thermally evaporated V1681 and C₆₀ thin films on quartz glass (thickness of 15 and 16 nm, respectively). Measurements were performed in ambient air in a wavelength range between 250 and 1200 nm with a 2 nm increment.

From the spectral transmission T and reflection R the absorbance A is determined via $A \left(λ\right) = 100 % - R \left(λ\right) - T \left(λ\right)$ (4)

The absorption coefficient *α* is then determined via: $α \left(λ\right) = \frac{2.303 ⋅ A \left(λ\right)}{d}$ (5) where d is the thickness of the layer.

For determining the reflection of perovskite/silicon tandem solar cells, spectral reflection measurements were performed using the same setup (wavelength range between 300 and 1200 nm, 5 nm increment).

### External quantum efficiency measurements on perovskite/silicon tandem solar cells:

EQEs of the perovskite top and silicon bottom subcells of tandem devices in this work were obtained in ambient air using a custom-built setup with a 450W xenon lamp (Newport) and Horiba Jobin Yvon iHR320 monochromator. A silicon diode was used as a monitor cell for detecting and considering light fluctuations. An unfiltered IR-extended WPVS reference cell (calibrated by Fraunhofer ISE CalLab) was used for the calibration of the setup prior to the measurement. The signals from the measured device and the monitor cell were recorded via two lock-in amplifiers (Signal recovery DSP 7225) and compiled by a custom LabView software. The EQE of the perovskite top cell was measured at wavelengths between 300 and 900 nm. For the silicon bottom cell, a wavelength range of 550 to 1200 nm was examined. The respective increment was 10 nm. The large illumination spot covered approximately half of the active area. In a monolithic tandem solar cell, the current of the whole device is determined by the subcell with the lower current. To extract the EQE of both subcells independently, the respective measured subcell needs to be current limiting. This is achieved by flooding the subcell that is not measured with light of a wavelength in its absorption range but outside of the absorption range of the measured cell. In this work, the perovskite top cell was flooded with light of an LED with a peak emission of 405 nm during the measurement of the silicon bottom cell. An LED with a peak emission of 950 nm was chosen for flooding the silicon subcell during the measurement of the perovskite subcell. Furthermore, to measure at short-circuit conditions, the photovoltage generated by the selectively flooded subcell needs to be compensated by a bias-voltage. Here, a bias voltage of 0.6 V and 0.9 V was applied during the EQE measurement of the perovskite top and silicon bottom cell respectively.

### Thermogravimetric analysis (TGA):

TGA was performed on a Q50 thermogravimetric analyser (TA Instruments) at a scan rate of 10 °C min⁻¹ in the nitrogen atmosphere.

### Xerographic time of flight (XTOF) measurements:

The samples for the electron mobility measurements were prepared by vacuum evaporation of the investigated compounds on the glass substrates with conductive Al layer. The evaporator temperature was 180-190°C. The ETM V1770 was deposited via spin-coating the THF solution of the compound. The layer thickness was in the range of 1.5-2.5 µm. The electron drift mobility was measured by xerographic time of flight technique (XTOF) (Vaezi-Nejad, S. M., Int. J. Electronics, 1987, 62, No 3, 361-384). An electric field was created by corona charging. The charge carriers were generated at the layer surface by illumination with pulses of nitrogen laser (pulse duration was 1 ns, wavelength 337 nm). The layer surface potential decrease as a result of pulse illumination was up to 1-2% of initial potential before illumination. The capacitance probe that was connected to the wide frequency band electrometer measured the discharge transient of surface potential. The transit time tt was determined by the kink on the curve of the *dU*/*dt* transient in double logarithmic scale or by half-discharge time on the integral transient curve. The drift mobility was calculated by the formula *µ=d*²/*U*₀*t*ₜ, where d is the layer thickness and *U*₀ is the surface potential at the moment of illumination.

### Example 3: Material properties

### Thermal Stability:

Thermal evaporation is a preferred deposition method for materials development, offering both scalability and potential compatibility with industrial fabrication processes. To assess the suitability of the synthesized ETMs for this deposition process, thermogravimetric analysis (TGA) was carried out to evaluate their thermal stability, volatility, and decomposition behaviour. TGA was performed on five materials - V1681 (ETM-1), V1760 (ETM-2), V1769 (ETM-3), V1781 (ETM-4), V1744 (ETM-7), and V1770 (ETM-8) - to evaluate their thermal stability and suitability for deposition via thermal evaporation (see **Fig. 3** and **Tab. 1**). Among these, materials V1681, V1760, V1769, V1781 and V1770 exhibited favourable behaviour, characterized by a relatively sharp onset of weight loss. The temperatures corresponding to 5% weight loss (T₅) for these samples were 386 °C, 348 °C, 284 °C, 312 °C and 353 °C, respectively, indicating adequate volatility and thermal stability for evaporation-based deposition processes. V1744 displayed a more gradual mass loss profile, with a T₅ of 370 °C, which may indicate partial decomposition and thus make it less ideal for clean evaporation. However, no issues were observed during the actual thermal evaporation process under vacuum conditions, suggesting that the material may still be practically viable despite its less favourable TGA profile.

It is further noted that for all carborane-based ETMs tested in perovskite solar cells - namely V1681, V1760, and V1744 - no visible changes were observed in the source powders after evaporation, suggesting that thermal decomposition during deposition is unlikely and supporting their practical viability for use in vacuum thermal evaporation. Moreover, the tested carborane-based materials exhibited sublimation temperatures in the range of 150 - 200 °C under vacuum conditions (1 - 3 · 10⁻⁶ mbar), which is substantially lower than the temperatures above 330 °C typically required to achieve comparable deposition rates with C₆₀. The reduced sublimation temperature offers practical advantages for vacuum processing, including lower energy input, and decreased thermal stress on both the evaporation source and deposition system components.

**Tab. 1: Temperatures of 5 and 10% weight loss, T₅ and T₁₀, from thermogravimetric analysis (TGA) of the synthesized electron transport materials (ETMs) V1681 (ETM-1), V1760 (ETM-2), V1769 (ETM-3), V1781 (ETM-4), V1744 (ETM-7), and V1770 (ETM-8).**

| **Material** | **T₅ [°C]** | **T₁₀ [°C]** |
|---|---|---|
| V1681 (ETM-1) | 386 | 412 |
| V1760 (ETM-2) | 348 | 362 |
| V1769 (ETM-3) | 284 | 300 |
| V1781 (ETM-4) | 312 | 327 |
| V1744 (ETM-7) | 370 | 449 |
| V1770 (ETM-8) | 353 | 368 |

### Electron mobilities:

To assess the charge transport properties of the carborane-based materials, the electron mobilities of thermally evaporated V1681 (ETM-1), V1760 (ETM-2), V1769 (ETM-3), V1781 (ETM-4) and spin-coated V1770 (ETM-8) were determined using xerographic time-of-flight (XTOF) measurements (see **Fig. 4** and **Tab. 2**). Among the materials tested, V1681 exhibited the highest electron mobility, with a value of 1.1 · 10⁻³ cm² V⁻¹ s⁻¹ at an applied field of 10⁶ V/cm, and a low Poole-Frenkel slope (α = 0.0032 (cm/V)^{1/2}), indicating efficient and relatively fieldinsensitive charge transport. In contrast, V1760, V1769 and V1781 showed slightly lower mobilities (6 · 10⁻⁴,1 · 10⁻⁴ and 1.4 · 10⁻⁴ cm² V⁻¹ s⁻¹ at 10⁶ V/cm, respectively) while spin-coated V1770 exhibited a significantly reduced mobility, with a value of 1.7 · 10⁻⁶ cm² V⁻¹ s⁻¹.

For comparison, widely used fullerene-based electron transport materials such as C₆₀ and or phenyl-C₆₁-butyric acid methyl ester (PCBM) typically exhibit electron mobilities in the range of 0.05 - 1 V⁻¹ s^{-1 [15-17]} and 10⁻⁴ - 10⁻³ cm² V⁻¹ s^{-1 [18-20]}, respectively. The mobility of V1681 is therefore comparable to that of PCBM, supporting its suitability as an efficient ETM in perovskite solar cells. In contrast, the significantly lower mobilities observed for V1770 may limit its effectiveness in device applications, while the intermediate mobility values for V1760 V1769 and V1781 suggest moderate transport performance that could still be suitable for the application in perovskite solar cells.

**Tab. 2: Summary of electron transport properties for carborane-based ETMs determined by xerographic time-of-flight (XTOF) measurements at room temperature. Listed are the layer thickness, zero-field electron mobility µ(0), field-dependent mobility at 10⁶ V/cm, and the Poole-Frenkel slope (α), which describes the field dependence of the mobility. V1681, V1760, V1769 and V1781 were deposited via thermal evaporation whereas the ETM V1770 was deposited via spin-coating (SC).**

| **Sample** | **Layer thickness [µm]** | ***µ* (0) [cm²/Vs]** | ***µ* (10⁶ V/cm) [cm²/Vs]** | *α* **[(cm/V)^{1/2}]** |
|---|---|---|---|---|
| V1681 (ETM-1) | 1.8 | ~5·10⁻⁵ | 1.1·10⁻³ | ~0.0032 |
| V1760 (ETM-2) | 2.3 | ~1·10⁻⁵ | 6·10⁻⁴ | ~0.0041 |
| V1769 (ETM-3) | 2.1 | 1.7·10⁻⁷ | 1·10⁻⁴ | 0.0064 |
| V1781 (ETM-4) | 2.1 | 3.2·10⁻⁶ | 1.4·10⁻⁴ | 0.0038 |
| SC V1770 (ETM-8) | 2.2 | 1·10⁻⁸ | 1.7·10⁻⁶ | 0.0052 |

### Example 4: Performance of perovskite solar cells:

To evaluate the carborane-based ETMs in opaque single-junction perovskite solar cells, we fabricated single-junction solar cells using a 1.68 eV triple-cation, triple-halide (3Hal) perovskite absorber - suitable also for the integration in perovskite/silicon tandem devices. A schematic of the solar cell stack is depicted in **Fig. 1a****.** Four ETM configurations were investigated: (i) C₆₀, (ii) no ETM (i.e., direct deposition of SnOₓ onto the perovskite), and (iii) three carborane-based ETMs - V1681, V1760, and V1744 (see molecule structure in **Fig. 1b-****d**) - each deposited by both thermal evaporation (thickness of 4 nm) and spin-coating, respectively. As represented in **Fig. 2a** the reference devices employing C₆₀ as ETM reached a median power conversion efficiency (PCE) of 19.4%. In contrast, devices without an additional ETM (w/o ETM) - where the SnOₓ buffer layer was deposited directly onto the perovskite - showed 0% efficiency and, hence, no evidence of charge extraction, indicating that SnOₓ does not function as an effective stand-alone electron-selective contact in this architecture, consistent with previous findings^{[21,22]}. Compared to the control without ETM, devices incorporating carborane-based ETMs exhibited clear indications of charge extraction, as evidenced by increased short-circuit current density (*J*_{SC}), and fill factor (FF) (see **Fig. 2b****, c**). Notably, higher FFs were observed when the carborane materials were deposited via thermal evaporation. This is likely due to improved film uniformity and conformality achieved

through this vacuum deposition process relative to spin-coating, which may promote more homogeneous interfaces and facilitate more efficient electron extraction. Among the carborane-based ETMs, V1681 and V1760 - featuring 9-fluorenylidene malononitrile functional groups on a *meta-* and *ortho*-carborane body, respectively - showed the highest open-circuit (*V*_{OC}) values, exceeding those of the C₆₀ reference devices and indicating a reduction in interfacial non-radiative recombination losses.

V1744 showed clear signs of charge extraction but yielded lower *J*_{SC}, *V*_{OC}, and FF than the other carborane-based ETMs tested in this series. This performance difference may arise from unfavourable energetic alignment with the perovskite and/or the SnOₓ layer. Based on literature reports^{[23]}, the addition of a nitro moiety on the fluorenylidene malononitrile functional group in V1744 can be expected to increase the material's electron affinity. This could lead to a larger offset between the perovskite conduction band minimum (CBM) and the ETM lowest unoccupied molecular orbital (LUMO), and/or the formation of an energy barrier at the ETM/SnOₓ interface - both of which may contribute to reduced device performance.

Overall, the highest performance was obtained using thermally evaporated V1681 as ETM, which resulted in a median PCE of 19.9%. Although the median FF (78.5%) was slightly lower than that of the C₆₀-based reference devices (81.9%), the V1681-based devices exhibited a *V*_{OC} that was 80 mV higher, leading to a net gain in overall efficiency of absolute 0.5%. The best-performing V1681-device reached a PCE of 21.7%, underscoring the potential of carborane-based ETMs as effective non-fullerene alternatives for high-efficiency perovskite solar cells.

To better understand the origin of charge extraction in the carborane-based ETMs, we systematically evaluated individual molecular fragments - namely, the *meta-* and *ortho-*carborane (*m*-CB and *o*-CB) cores, as well as 4-carboxy-9-fluorenylidene malononitrile (V1722) and 4-nitro-9-fluorenylidene malononitrile methyl ester (V1746), which closely resemble the functional groups used in V1681 and V1760, and V1744, respectively (see molecule structure in **Fig. 5a****-d**).

Devices fabricated with *m*-CB and *o*-CB (deposited via spin-coating) did not show any indication of charge extraction. Both the *J*_{SC} and FF remained comparable to the devices w/o ETM, indicating negligible electron collection. These results suggest that the bare carborane cores alone do not enable electron extraction in this configuration. One possible explanation is that the carborane layers due to the volatile nature of these molecules are partially removed during the subsequent SnOₓ ALD process, which is conducted under vacuum. However, complete removal is unlikely given the short vacuum exposure time (3-5 min) and the relatively moderate vacuum pressure (~0.3 mbar) applied prior to SnOₓ deposition. Therefore, we propose that the carborane molecules tested here are insufficient for effective electron extraction in the tested solar cell architecture.

In contrast, both spin-coated 9-fluorenylidene malononitrile derivatives without the carborane core (V1722 and V1746) demonstrated clear signs of charge extraction, with V1722 outperforming V1746 in terms of photovoltaic parameters. These findings are consistent with the results obtained for the complete molecules in **Fig. 2a****-d,** where V1681 and V1760 - both of which feature V1722-like functional group - also performed better than V1744, which incorporates V1746-like moieties. From these results, we infer that the functional moieties are key contributors to enabling charge extraction in the tested carborane-based ETMs. 9-fluorenylidene malononitrile derivates have previously been employed in fullerene-based organic solar cells to improve thermal stability through charge-transfer interactions with the donor polymer^{[23]}. While the material context differs, this highlights the capacity of the functional group to engage in electronic interactions relevant to charge separation. More broadly, cyanocapped molecules are widely used as electron acceptors due to its strongly electronwithdrawing nature^{[24-27]}.

On the other hand, it is inferred that the carborane core plays an essential role in tuning other critical properties such as charge carrier mobility, molecular packing, and/or film morphology. The difference in device performance between V1681 and V1760 supports this interpretation: although both materials share the same functional group, they differ in the type and substitution pattern of the carborane cage. As discussed above, XTOF measurements further revealed that V1760 exhibits lower electron mobility than V1681. Both materials show clear evidence of charge extraction - most likely associated with the functional group - yet their device performance and transport characteristics differ, likely due to factors governed by the position of the functional group on the carborane as well as the structural characteristics of the core itself.

### Example 5: V1681 (ETM-1) - film and material characteristics:

The highest device performance in this study was achieved using V1681 as the ETM. Consequently, further characterization focused on this material. Transient surface photovoltage (trSPV) measurements on perovskite solar cell half-stacks incorporating V1681 **(****Fig. 6a****)** exhibit a rapid rise in the negative SPV signal upon excitation with a 700 nm wavelength laser, indicative of efficient electron extraction. Compared to reference half-stacks employing C₆₀, the V1681-based samples show a slightly reduced initial slope, suggesting slower charge extraction kinetics, which is consistent with the slightly lower FF observed in complete devices. However, the significantly higher SPV amplitude observed for samples with V1681 suggests a larger number of separated charge carriers and thus could hint toward reduced non-radiative recombination. This interpretation is supported by transient photoluminescence (trPL) measurements on the same stacks **(****Fig. 6b****),** which show enhanced differential lifetimes across the entire quasi-Fermi level splitting (QFLS) range, suggesting reduced non-radiative recombination losses. Steady-state photoluminescence (PL) measurements **(****Fig. 6c****)** further confirm this conclusion, showing substantially enhanced PL intensity in V1681-containing stacks compared to those with C₆₀. The corresponding QFLS values **(****Fig. 6d****)** reveal a 70 meV increase for solar cell partial stacks with V1681 (1.24 eV) relative to the C₆₀ counterparts (1.17 eV), underscoring the reduction in non-radiative recombination and suggesting the formation of a high-quality perovskite/ETM interface.

The improved interfacial quality observed with V1681 may be attributed to several factors. In the case of C₆₀, prior studies have identified high non-radiative recombination losses at the perovskite/C₆₀ interface, which have been linked to an unfavourable energetic alignment between the perovskite CBM and the LUMO of C₆₀, as well as a high density of interfacial ingap states^{[28,29]}. In contrast, the V1681/perovskite interface may benefit from more favourable energetic alignment and/or a lower density of electronic trap states. In addition, the presence of cyano (CN) groups in V1681 could contribute to defect passivation at the perovskite surface, as CN moieties are known to passivate undercoordinated Pb²⁺, thereby potentially mitigating trap-assisted recombination pathways at the interface^{[30-32]}.

The energy levels of V1681 were determined and compared to those of the 3Hal perovskite to evaluate interfacial alignment. He-I ultraviolet photoemission spectroscopy (He-UPS) was used to estimate the Fermi level position and valence band maximum (VBM) of the perovskite, as well as the highest occupied molecular orbital (HOMO) of V1681. The CBM of the perovskite and the LUMO of V1681 were determined by adding their respective band gaps - 1.68 eV for the perovskite and 3.1 eV (determined by UV-Vis-NIR spectroscopy) for V1681 - to the VBM and HOMO energies. As shown in **Fig. 7** the resulting energy level alignment reveals favourable conditions for electron extraction, in line with the findings from *J-V* and trSPV measurements. Relative to the vacuum level, the CBM of the perovskite lies at -3.86 eV, while that of V1681 is at -4.06 eV, yielding a 0.20 eV downhill offset. V1681 exhibits highly n-type character, with a Fermi level positioned at -4.18 eV compared to -4.91 eV for the perovskite. This Fermi level mismatch drives electron flow from the ETM to the perovskite upon contact, inducing downward band bending in the perovskite that further enhances electron extraction and reduces the minority carrier (hole) concentration at the interface. Additionally, the perovskite VBM at -5.54 eV lies 1.59 eV above the deep HOMO of V1681 (-7.13 eV), effectively suppressing hole injection. Together, these characteristics establish a highly selective interface that supports efficient charge extraction while minimizing interfacial recombination.

To further investigate the layer properties of V1681, we evaluated the surface free energy (SFE) and its polar and dispersive components using contact angle measurements with water and diiodomethane **(Tab. 3).** The layer stack with C₆₀ as top layer exhibited a high water contact angle (96°) and no measurable polar component, consistent with a non-polar, hydrophobic surface. In contrast, the V1681-based ETM showed a substantially lower water contact angle and small but distinct polar contributions (3.5-3.8 mN/m), indicating increased surface polarity. This increase may promote improved initial nucleation and better growth of the subsequently deposited SnOₓ layer by ALD. Moreover, the similar SFE values observed for 4 nm and 16 nm thick V1681 layers may indicate that a continuous surface coverage is already achieved at 4 nm. This is further supported by scanning electron microscopy (SEM) imaging of a sample with 4 nm thermally evaporated V1681 deposited on the perovskite, which show no visible pinholes and indicate a uniform, continuous film **(see** **Fig. 8****).**

**Tab. 3: Contact angles (CA) of water (H₂O) and diiodo-methane (MI) on solar cell partial stacks glass/indium tin oxide (ITO)/self-assembled monolayer (SAM)/triple-cation triple-halide (3Hal) perovskite/electron transport material (ETM) with 16 nm C₆₀, 4 nm V1681 or 16 nm V1681 as ETM and respective surface free energies as well as their disperse and polar parts.**

| **Layer stack** | **CA H₂O [°]** | **CA MI [°]** | **Disperse [mN/m]** | **Polar [mN/m]** | **SFE [mN/m]** |
|---|---|---|---|---|---|
| Pero/16 nm C₆₀ | 96.0 | 8.8 | 50.2 | 0 | 50.2 |
| Pero/4 nm V1681 | 76.7 | 31.7 | 43.5 | 3.8 | 47.3 |
| Pero/16 nm V1681 | 77.9 | 33.0 | 42.9 | 3.5 | 46.5 |

### Example 6: Optical benefit of V1681 (ETM-1) as ETM in perovskite/silicon tandem solar cells:

We demonstrated that V1681 can be effectively employed as an ETM in perovskite solar cells using a 1.68 eV wide-bandgap perovskite absorber, making it suitable for integration into monolithic perovskite/silicon tandem architectures. Moreover, the wide band gap of V1681 makes it attractive not only for its good electron selectivity when paired with wide-bandgap absorbers, but also for its potential to minimize optical losses. As shown in **Fig. 9a****,** V1681 absorbs at wavelengths below ~450 nm, whereas C₆₀ exhibits absorption extending up to ~650 nm. This difference in spectral absorption makes V1681 particularly attractive for tandem applications, where illumination through the ETM necessitates low parasitic absorption to maximize top cell current. This advantage was confirmed by external quantum efficiency (EQE) measurements on tandem devices incorporating either 16 nm C₆₀ or 4 nm V1681 as ETM **(****Fig. 9b****).** Devices using V1681 exhibited clearly reduced parasitic absorption at wavelengths below 600 nm and yielded an increased top cell current density by 0.66 mA/cm² compared to their C₆₀-based counterparts. This may be attributed not only to the comparably large band gap of the material but also its small layer thickness. The results indicate that V1681 not only contributes to the higher *V*_{OC} observed in single-junction devices but also has the potential to enhance *J*_{SC} in tandem configurations.

Overall, TGA confirmed the thermal stability and volatility of several carborane-based ETM derivatives, supporting their compatibility with thermal evaporation and enabling scalable deposition processes. Among the tested materials, V1681 emerged as the most promising candidate, exhibiting suitable electron mobility and delivering high photovoltaic performance that exceeded that of reference devices employing C₆₀ when integrated into single-junction perovskite solar cells with a 1.68 eV absorber. Comparative testing of molecular fragments revealed that the 9-fluorenylidene malononitrile functional group is essential for enabling electron extraction, while the nature and substitution pattern of the carborane core is assumed to influence parameters such as electron mobility, molecular packing, and/or film morphology. A combination of trSPV, transient and steady-state PL, and He-UPS measurements revealed the formation of a high-quality interface between the perovskite and V1681, resulting in low non-radiative recombination losses, and a highly electron-selective interface with exceptional hole-blocking ability. Contact angle measurements and SEM imaging further suggested that thermally evaporated V1681 forms uniform, pinhole-free films at low thickness. Finally, integration of V1681 into perovskite/silicon tandem solar cells demonstrated a clear optical advantage, with reduced parasitic absorption and increased top cell current compared to C₆₀. Overall, these results demonstrate the potential of the carborane-based ETM V1681 as a viable, non-fullerene ETM for efficient perovskite-based single-junction and multi-junction solar cells.

### Cited references:

[1] G. Jones, in Org. React., John Wiley & Sons, Ltd, 2011, pp. 204-599.
[2] C.-H. Lee, G. F. Jin, J. G. Joung, J.-D. Lee, H. S. Ban, H. Nakamura, J.-K. Cho, S. O. Kang, Tetrahedron Lett. 2009, 50, 2960.
[3] T. Ogawa, K. Ohta, T. Yoshimi, H. Yamazaki, T. Suzuki, S. Ohta, Y. Endo, Bioorg. Med. Chem. Lett. 2006, 16, 3943.
[4] Y. Endo, C. Songkram, R. Yamasaki, A. Tanatani, H. Kagechika, K. Takaishi, K. Yamaguchi, J. Organomet. Chem. 2002, 657, 48.
[5] X. Men, Y. Cheng, G. Chen, J. Bao, J. Yang, High Perform. Polym. 2015, 27, 497.
[6] G. Li, S. Azuma, H. Minegishi, H. Nakamura, J. Organomet. Chem. 2015, 798, 189.
[7] A. Kovredov, Z. Shaugumbekova, V. Kazantsev, L. Zakharkin, Zhurnal Obshchei Khimii 1986, 56, 2316.
[8] K. Ohta, H. Yamazaki, Y. Endo, Tetrahedron Lett. 2006, 47, 1937.
[9] A. Cruz, D. Erfurt, P. Wagner, A. B. Morales-Vilches, F. Ruske, R. Schlatmann, B. Stannowski, Sol. Energy Mater. Sol. Cells 2022, 236, 111493.
[10] P. Tockhorn, J. Sutter, A. Cruz, P. Wagner, K. Jäger, D. Yoo, F. Lang, M. Grischek, B. Li, J. Li, O. Shargaieva, E. Unger, A. Al-Ashouri, E. Köhnen, M. Stolterfoht, D. Neher, R. Schlatmann, B. Rech, B. Stannowski, S. Albrecht, C. Becker, Nat. Nanotechnol. 2022, 17, 1214.
[11] T. Unold, L. Gütay, in Adv. Charact. Tech. Thin Film Sol. Cells, Wiley-VCH, Weinheim, Germany, 2016, pp. 275-297.
[12] Y. Yuan, G. Yan, C. Dreessen, T. Rudolph, M. Hülsbeck, B. Klingebiel, J. Ye, U. Rau, T. Kirchartz, Nat. Mater. 2024, 23, 391.
[13] A. Rudawska, E. Jacniacka, Int. J. Adhes. Adhes. 2009, 29, 451.
[14] D. Y. Kwok, A. W. Neumann, Adv. Colloid Interface Sci. 1999, 81, 167.
[15] A. A. Said, E. Aydin, E. Ugur, Z. Xu, C. Deger, B. Vishal, A. Vlk, P. Dally, B. K. Yildirim, R. Azmi, J. Liu, E. A. Jackson, H. M. Johnson, M. Gui, H. Richter, A. R. Pininti, H. Bristow, M. Babics, A. Razzaq, T. G. Allen, M. Ledinský, I. Yavuz, B. P. Rand, S. De Wolf, Nat. Commun. 2024, 15, 708.
[16] R. Könenkamp, G. Priebe, B. Pietzak, Phys. Rev. B 1999, 60, 11804.
[17] A. Tapponnier, I. Biaggio, P. Günter, Appl. Phys. Lett. 2005, 86, 112114.
[18] C. Gong, H. Li, Z. Xu, Y. Li, H. Wang, Q. Zhuang, A. Wang, Z. Li, Z. Guo, C. Zhang, B. Wang, X. Li, Z. Zang, Nat. Commun. 2024, 15, 9154.
[19] C. Kuang, G. Tang, T. Jiu, H. Yang, H. Liu, B. Li, W. Luo, X. Li, W. Zhang, F. Lu, J. Fang, Y. Li, Nano Lett. 2015, 15, 2756.
[20] G.-J. A. H. Wetzelaer, P. W. M. Blom, J. Mater. Chem. C 2021, 9, 16068.
[21] A. F. Palmstrom, J. A. Raiford, R. Prasanna, K. A. Bush, M. Sponseller, R. Cheacharoen, M. C. Minichetti, D. S. Bergsman, T. Leijtens, H.-P. Wang, V. Bulović, M. D. McGehee, S. F. Bent, Adv. Energy Mater. 2018, 8, 1800591.
[22] A. Hultqvist, T. J. Jacobsson, S. Svanström, M. Edoff, U. B. Cappel, H. Rensmo, E. M. J. Johansson, G. Boschloo, T. Törndahl, ACS Appl. Energy Mater. 2021, 4, 510.
[23] C. H. Y. Ho, H. Cao, Y. Lu, T.-K. Lau, S. H. Cheung, H.-W. Li, H. Yin, K. L. Chiu, L.-K. Ma, Y. Cheng, S.-W. Tsang, X. Lu, S. K. So, B. S. Ong, J. Mater. Chem. A 2017, 5, 23662.
[24] H. I. Kim, M.-J. Kim, K. Choi, C. Lim, Y.-H. Kim, S.-K. Kwon, T. Park, Adv. Energy Mater. 2018, 8, 1702872.
[25] W. Yan, Z. He, J. Jiang, D. Lu, Y. Gong, W. Yang, R. Xia, W. Huang, H. Xin, J. Mater. Chem. C 2020, 8, 14773.
[26] X. Huang, D. Xia, Q. Xie, D. Wang, Q. Li, C. Zhao, J. Yin, F. Cao, Z. Su, Z. Zeng, W. Jiang, W. Kaminsky, K. Liu, F. R. Lin, Q. Feng, B. Wu, S.-W. Tsang, D. Lei, W. Li, A. K.-Y. Jen, Nat. Commun. 2025, 16, 1626.
[27] H. Wang, C. Zhao, Z. Burešová, F. Bureš, J. Liu, J. Mater. Chem. A 2023, 11, 3753.
[28] J. Warby, F. Zu, S. Zeiske, E. Gutierrez-Partida, L. Frohloff, S. Kahmann, K. Frohna, E. Mosconi, E. Radicchi, F. Lang, S. Shah, F. Peña-Camargo, H. Hempel, T. Unold, N. Koch, A. Armin, F. De Angelis, S. D. Stranks, D. Neher, M. Stolterfoht, Adv. Energy Mater. 2022, 12, 2103567.
[29] D. Menzel, A. Al-Ashouri, A. Tejada, I. Levine, J. A. Guerra, B. Rech, S. Albrecht, L. Korte, Adv. Energy Mater. 2022, 12, 2201109.
[30] X. Sun, C. Zhang, D. Gao, X. Yu, B. Li, X. Wu, S. Zhang, Y. He, Z. Yu, L. Qian, J. Gong, S. Li, N. Li, Z. Zhu, Z. Li, Angew. Chem. Int. Ed. 2025, 64, e202412819.
[31] Z. He, Z. Zhang, J. Ding, W. Gao, M. Li, C. Chen, Small 2024, 20, 2404334.
[32] J. Wang, J. Zhang, Y. Zhou, H. Liu, Q. Xue, X. Li, C.-C. Chueh, H.-L. Yip, Z. Zhu, A. K. Y. Jen, Nat. Commun. 2020, 11, 177.

All scientific publications and patent documents cited in the present specification are incorporated by reference herein.

## Claims

1. A compound, comprising a substituted carborane, substituted with at least one functional group selected from the group consisting of substituted fluorenylidene, wherein the carborane is substituted at one or more boron atom and/or at one or more carbon atom, in particular, wherein the carborane is substituted at one or more carbon atom.

2. The compound according to claim 1, wherein the carborane is selected from the group consisting of ortho-carborane, meta-carborane or para-carborane, in particular, wherein the carborane is selected from the group consisting of ortho-carborane, and meta-carborane.

3. The compound according to claim 1 or 2, wherein the carborane is selected from the groups consisting of *closo*-carborane, *vertex*-carborane, *nido*-carborane and *arachno*carborane, in particular, wherein the carborane is selected from the groups consisting of *closo*-carborane and *vertex*-carborane, wherein the carborane is selected from the group consisting of *closo*-carborane.

4. The compound according to any of the preceding claims, wherein the carborane is a closo-dicarbadecaborane or a vertex-dicarbaoctocarborane, in particular the carborane is selected from the group consisting of 1,2-*closo*-dicarbadecaborane, *1,7-closo-*dicarbadecaborane, 1,12-*closo*-dicarbadecaborane, 1,6-*vertex*-dicarbaoctocaborane, 1,2-*vertex*-dicarbaoctocaborane, and 1,10-*vertex*-dicarbaoctocaboranem more particularly the carborane is selected from the group consisting 1,2-*closo-*dicarbadecaborane, 1,7-*closo*-dicarbadecaborane, 1,6-*vertex*-dicarbaoctocaborane, 1,2-*vertex*-dicarbaoctocaborane.

5. The compound according to any of the preceding claims is selected from any one of the formulae (I) to (VI) 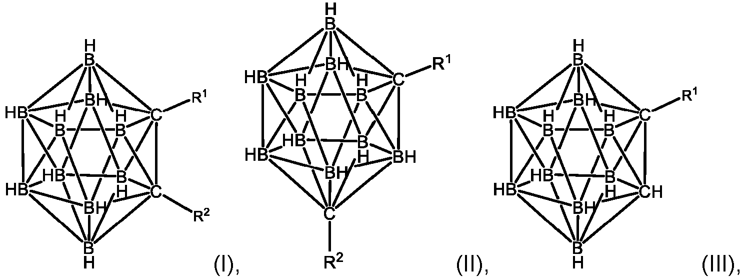 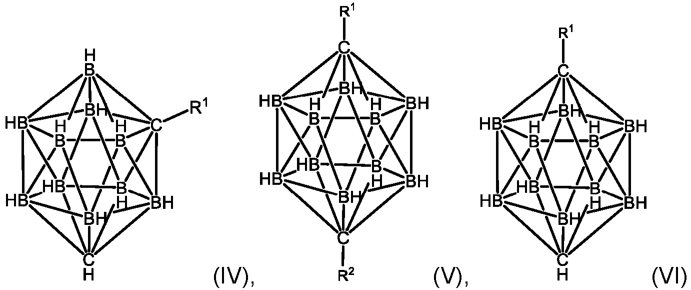
wherein R¹ and R² are each selected from the group consisting of substituted fluorenylidene,
in particular wherein the compound is of formula (I) or (II) or (III).

6. The compound according to any of the preceding claims, wherein R¹ and R² are each selected from a substituted fluorenylidene of formula (VII) 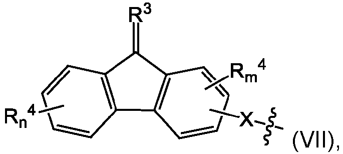 wherein
each R⁴ is selected from any of the groups consisting of
- -F, -Cl, -Br, -I;
- -NO₂, -OH, -NH₂;
- -O-C₁-C₆ alkyl, -C₁-C₆ alkyl, -C₂-C₆ alkenyl;
- aryl;
- heterocycle;
wherein n is an integer of 0, 1, 2, 3 or 4 and m is an integer of 0, 1, 2 or 3;
X is a linking fragment connecting the substituted fluorenylidene with the carborane selected from any of the groups consisting of
- -C₁-C₃₀ alkyl-, -Y-C₁-C₃₀ alkyl-, -C₁-C₃₀ alkyl-Y-C₁-C₃₀ alkyl-, -C₁-C₃₀ alkyl-Y-, wherein Y is selected from the group consisting of -O-, -S-, -C(=O)-, - C(=O)O-, -SiO-, -SO₂-, -PO₂-, -aryl-, -heterocycle-, -cycloalkyl-, -SiR⁵R⁶-, - BR⁵-, -NR⁵-, wherein R⁵ and R⁶ are each selected from the group consisting of -H, -F, -Cl-, -Br, -I, -OH, -SH, -OC₁-C₆ alkyl, -C₁-C₆ alkyl, -C₂-C₆ alkenyl, aryl, heterocycle, cycloalkyl;
- -C(=O)-O-, -C(=O)S-, -C(=O)OSi(CH₃)₂-, -C(=O)NH-;
- -C(=O)NH-phenyl-, -C(=O)O-phenyl-,
- 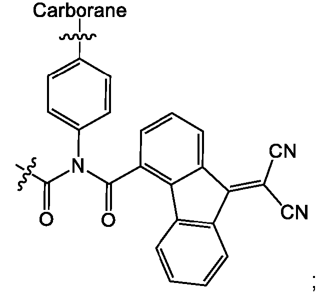
R³ is selected from the group consisting of 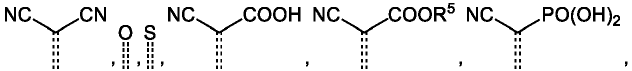 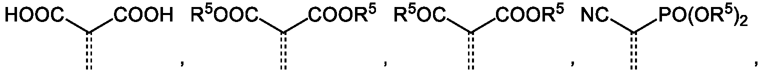 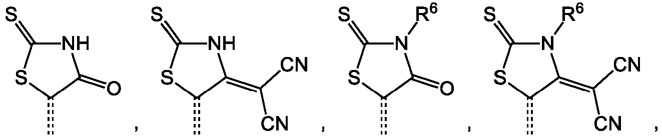 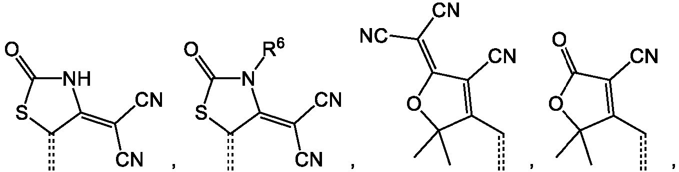 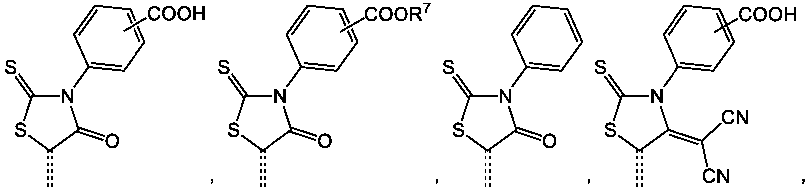 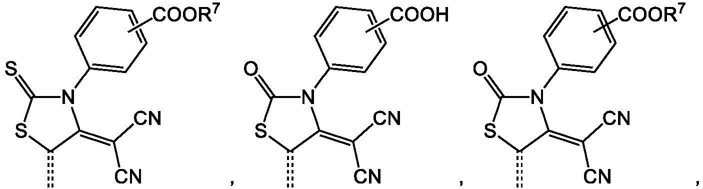 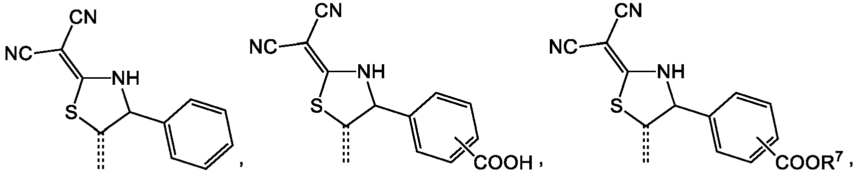 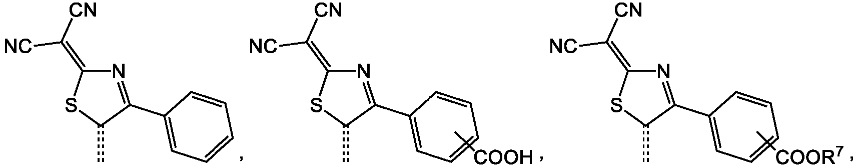 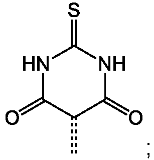
wherein
R⁵ is selected from the group consisting of unsubstituted -C₁-₄ alkyl,
R⁶ is selected from the groups consisting of unsubstituted -C₁-₄ alkyl, -C₁-₄ alkyl-COOH, and -C₁-₄ alkyl-COOR⁸, wherein R⁸ is selected from the group consisting of unsubstituted -C₁-₄ alkyl,
R⁷ is selected from the group consisting of unsubstituted -C₁-₄ alkyl,
and wherein the dashed bond represents the double bond connecting R³ and fluorenylidene in formula (VII).

7. The compound according to any of the preceding claims, wherein R⁴ₙ is selected from any of the groups consisting of
- -F, -CI, -Br, -I;
- -NO₂, -OH, -NH₂;
- -O-C₁-C₆ alkyl, -C₁-C₆ alkyl, -C₂-C₆ alkenyl;
wherein n is an integer of 0, 1, 2, 3 or 4 and m is an integer of 0, 1, 2 or 3;
in particular wherein R⁴ₙ is selected from any of the groups consisting of
- -F, -CI, -Br, -I;
- -NO₂, -OH, -NH₂;
wherein n is an integer of 0, 1, 2, 3 or 4 and m is an integer of 0, 1, 2 or 3;
more particularly, wherein R⁴ₙ is selected from the group consisting of
- -NO₂, -OH, -NH₂;
wherein n is 0 or 1 and m is 0 or 1.

8. The compound according to any of the preceding claims, wherein X is a linking fragment selected from any of the groups consisting of
- -Y-C₁-C₃₀ alkyl-, wherein Y is -C(=O)O-;
- -C(=O)-O-, -C(=O)S-, -C(=O)OSi(CH₃)₂-
- - C(=O)NH-phenyl-, -C(=O)O-phenyl-;
- 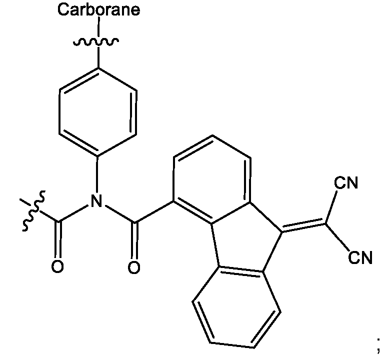
in particular, wherein X is a linking fragment selected from any of the groups consisting of
- -Y-C₁-C₃- alkyl-, wherein Y is -C(=O)O-;
- -C(=O)-O-, -C(=O)S-, -C(=O)OSi(CH₃)₂-
- -C(=O)NH-phenyl-, -C(=O)O-phenyl-;
- 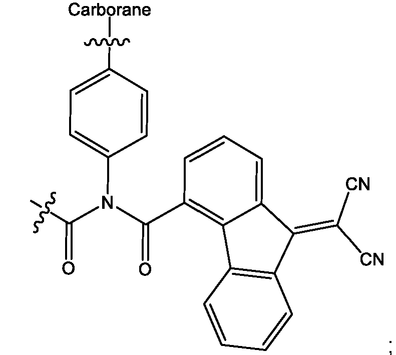
more particularly wherein X is a linking fragment selected from any of the groups consisting of
- -Y-C₁-C₃- alkyl-, wherein Y is -C(=O)O-;
- -C(=O)-O-.

9. The compound according to any of the preceding claims, wherein R³ is selected from the group consisting of 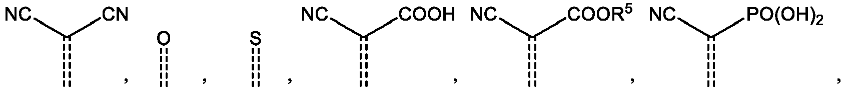 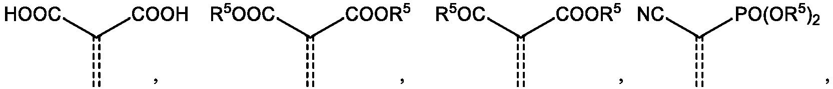 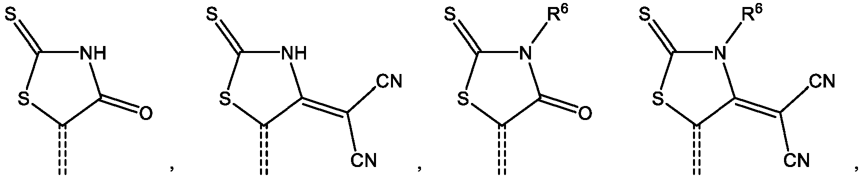 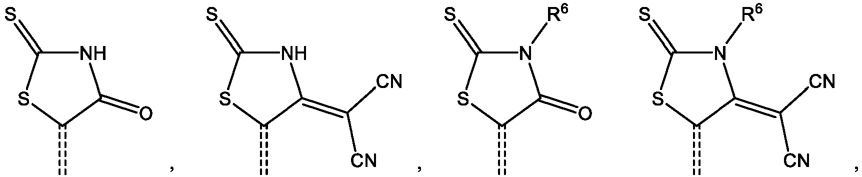 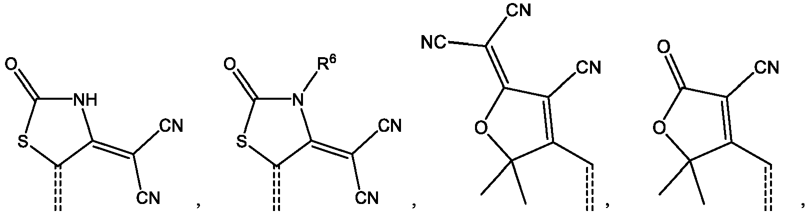 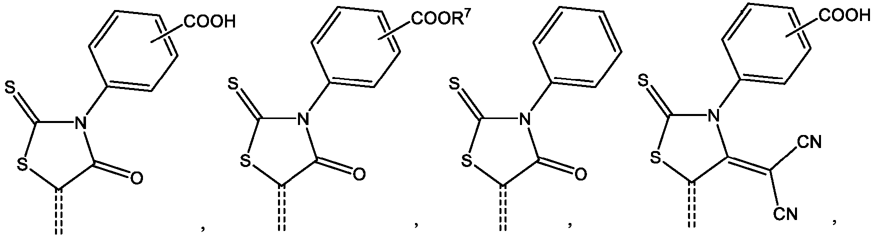 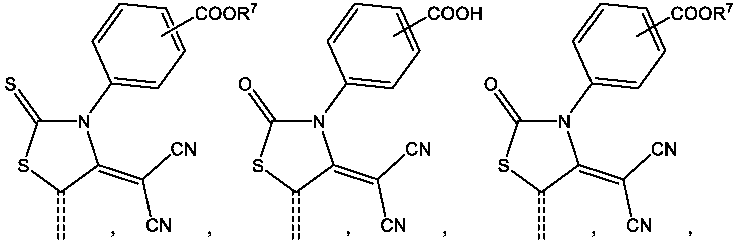 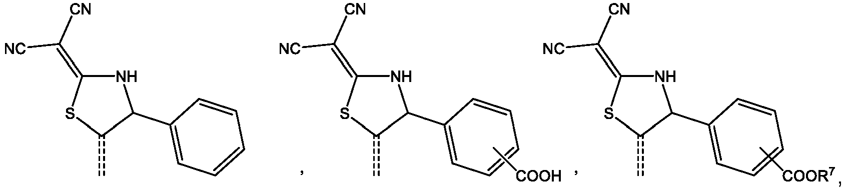 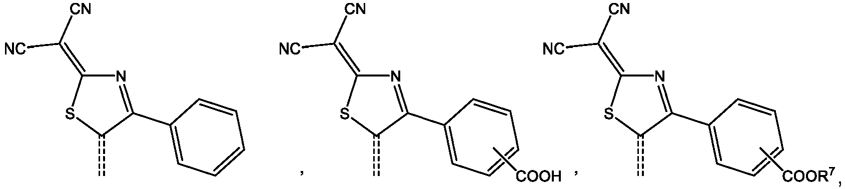 wherein
R⁵ is selected from the group consisting of an unsubstituted -C₁-₄ alkyl,
R⁶ is selected from the groups consisting of unsubstituted -C₁-₄ alkyl, C₁-₄ alkyl-COOH, and -C₁-₄ alkyl-COOR⁸, wherein R⁸ is selected from the group consisting of unsubstituted -C₁-₄ alkyl,
R⁷ is selected from the group consisting of unsubstituted -C₁-₄ alkyl,
and wherein the dashed bond represents the double bond connecting R³ and fluorenylidene in formula (VII);
in particular wherein R³ is selected from the group consisting of 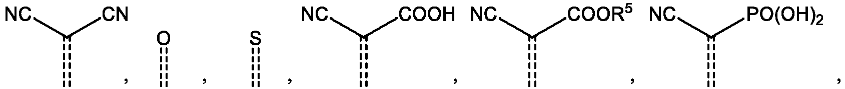 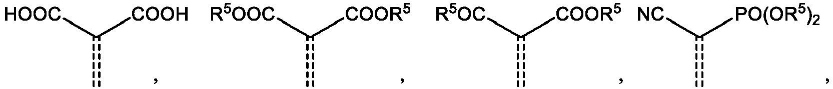 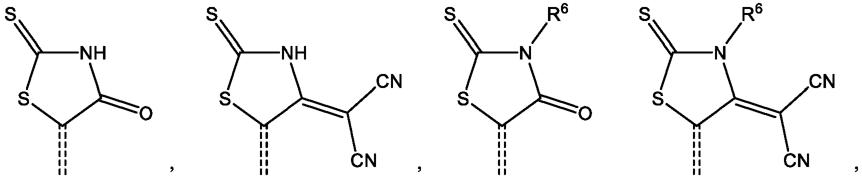 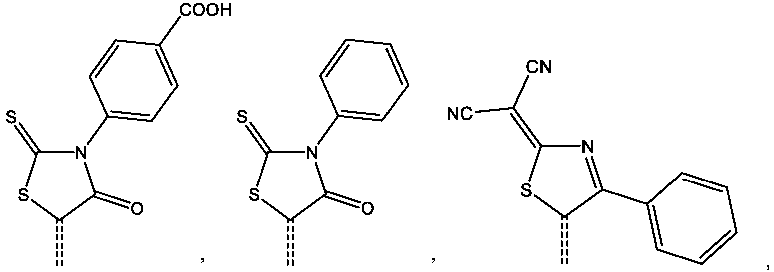 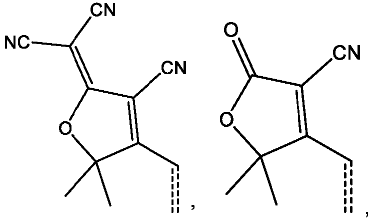
wherein
R⁵ is selected from the group consisting of unsubstituted -C₁-₄ alkyl,
R⁶ is selected from the groups consisting of unsubstituted -C₁-₄ alkyl, -C₁-₄ alkyl-COOH, and -C₁-₄ alkyl-COOR⁸, wherein R⁸ is selected from the group consisting of unsubstituted C₁-₄ alkyl,
and wherein the dashed bond represents the double bond connecting R³ and fluorenylidene in formula (VII);
more particularly wherein R³ is selected from the group consisting of 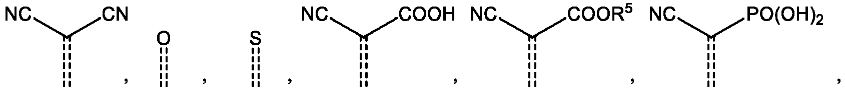 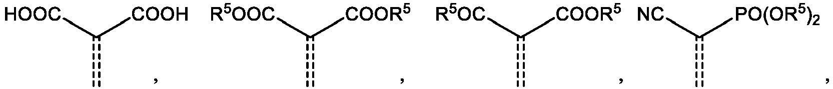 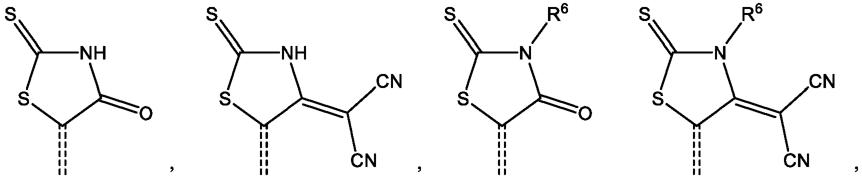 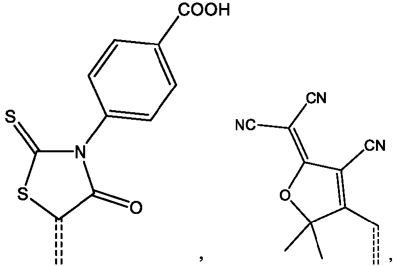
wherein
R⁶ is selected from the group consisting of an unsubstituted -C₁-₄ alkyl,
R⁶ is selected from the groups consisting of unsubstituted -C₁-₄ alkyl, -C₁-₄ alkyl-COOH, and -C₁-₄ alkyl-COOR⁸, wherein R⁸ is selected from the group consisting of unsubstituted -C₁-₄ alkyl, in particular R⁶ is selected from the groups consisting of unsubstituted -C₁-₄ alkyl, and C₁-₄ alkyl-COOH;
and wherein the dashed bond represents the double bond connecting R³ and fluorenylidene in formula (VII).

10. The compound according to any of the preceding claims, wherein R³ is selected from the group consisting of 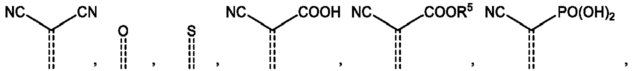 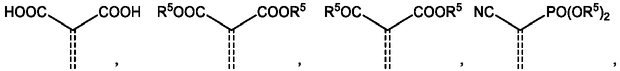 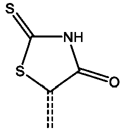 wherein
R⁵ is selected from the group consisting of unsubstituted C₁-₄ alkyl,
and wherein the dashed bond represents the double bond connecting R³ and fluorenylidene in formula (VII);
in particular wherein R³ is selected from the group consisting of 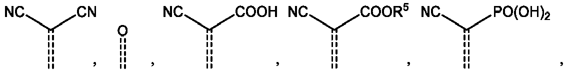 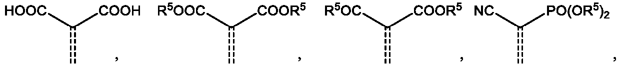
wherein
R⁵ is selected from the group consisting of unsubstituted -C₁-₄ alkyl,
and wherein the dashed bond represents the double bond connecting R³ and fluorenylidene in formula (VII);
more particularly wherein R³ is selected from the group consisting of 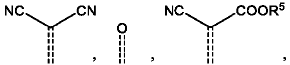
wherein
R⁵ is selected from the group consisting of unsubstituted -C₁-₄ alkyl,
and wherein the dashed bond represents the double bond connecting R³ and fluorenylidene in formula (VII).

11. The compound according to any of the preceding claims, wherein R¹ and R² are each selected from a substituted fluorenylidene of formula (Vlla) or (Vllb) 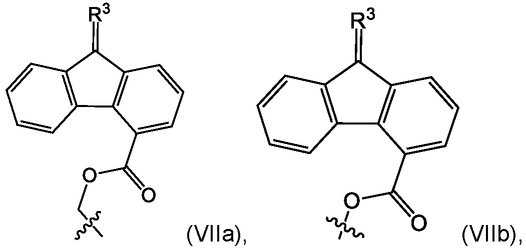 wherein
R³ is selected from the group consisting of 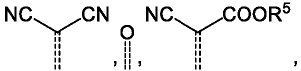
wherein
R⁵ is selected from the group consisting of unsubstituted -C₁-₄ alkyl,
and wherein the dashed bond represents the double bond connecting R³ and fluorenylidene in formula (VII);
in particular, wherein R¹ and R² are each a substituted fluorenylidene of formula (Vlla) or (VIIb) or (VIIc)

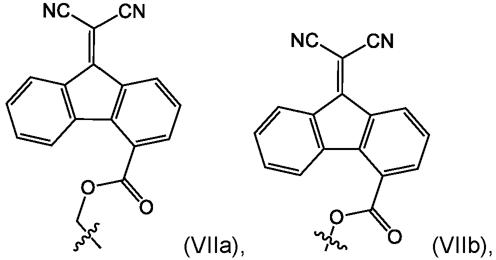

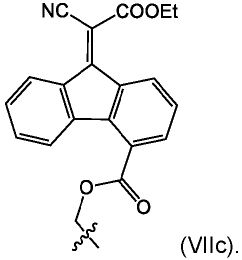

12. The compound according to any of the preceding claims, selected from a compound of any of the formulae (ETM-1), (ETM-2), (ETM-3), (ETM-4), (ETM-7) and (ETM-8), in particular selected from a compound of the formulae (ETM-1) or (ETM-2),

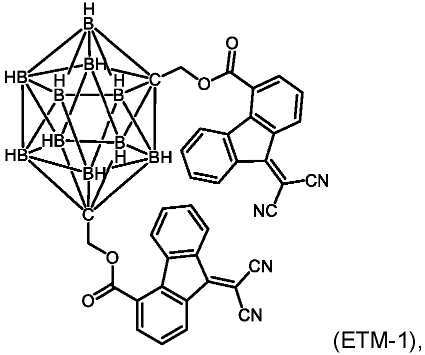

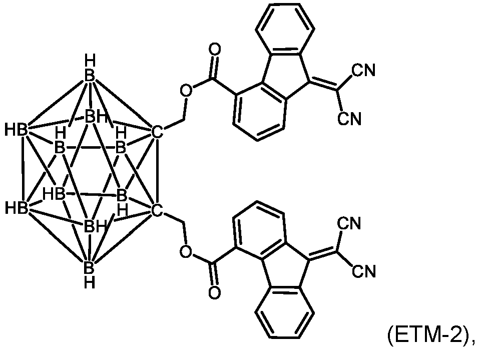

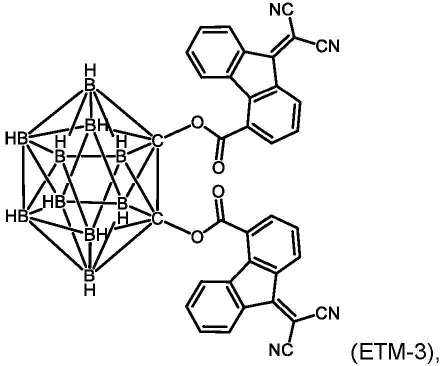

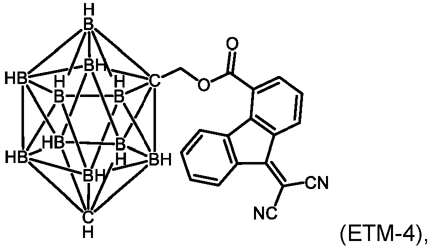

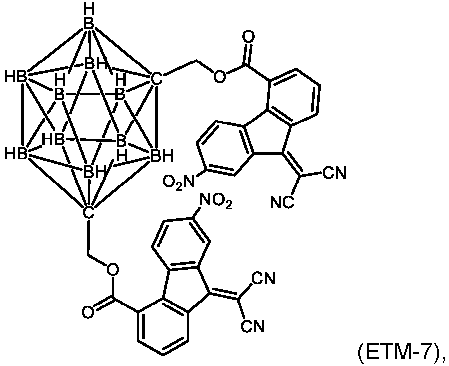

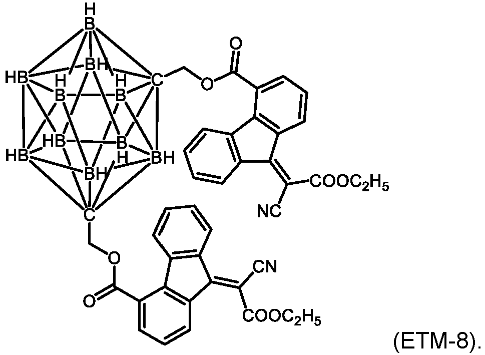

13. An electron transporting material comprising a compound according to claims 1 to 12.

14. A solar cell comprising one or more layers of an electron transporting material according to claim 13 and one or more layers of perovskite, wherein the solar cell is a p-i-n solar cell.

15. The solar cell according to claim 14, wherein the solar cell further comprises one or more layers of a hole transporting material, a transparent conducting oxide substrate and an electrode.
